# EUROPÄISCHE PATENTSCHRIFT

(11) **EP 3 667 919 B1**
(45) Veröffentlichungstag und Bekanntmachung des Hinweises auf die Patenterteilung: **04.11.2026**
(21) Anmeldenummer: 19215102.5
(22) Anmeldetag: 11.12.2019
(51) Int. Cl.: H03K 17/955, E05F 15/73

(54) **ANORDNUNG FÜR EIN FAHRZEUG**
ASSEMBLY FOR A VEHICLE
AGENCEMENT POUR UN VÉHICULE

(30) Priorität: 12.12.2018 DE 102018131862
(43) Veröffentlichungstag der Anmeldung: 17.06.2020
(73) Patentinhaber: Huf Hülsbeck & Fürst GmbH & Co. KG, 42551 Velbert (DE)
(72) Erfinder: STAHL, Daniel, 31515 Wunstorf (DE)
(74) Vertreter: Bals & Vogel Patentanwälte PartGmbB

(56) Entgegenhaltungen:
- EP-A1- 2 112 476
- EP-B1- 1 537 665
- WO-A1-97/01835
- US-A1- 2003 071 727
- US-A1- 2010 315 234
- US-A1- 2014 015 640

## Beschreibung

Die vorliegende Erfindung betrifft eine Anordnung für ein Fahrzeug zur Detektion einer Aktivierungshandlung für die Aktivierung einer Funktion am Fahrzeug.

Ferner bezieht sich die Erfindung auf ein System sowie ein Verfahren.

Es ist aus dem Stand der Technik bekannt, dass mittels eines Sensorelements, wie einer Sensorelektrode, eine veränderliche Kapazität bereitgestellt werden kann, welche für Veränderungen in der Umgebung des Sensorelements spezifisch ist. Dies ermöglicht es, Änderungen in der Umgebung kapazitiv zu erfassen. Bei Fahrzeugen kann eine derartige kapazitive Erfassung genutzt werden, um Annäherungen und/oder Gesten zu detektieren, und damit Funktionen am Fahrzeug zu aktivieren.

Eine kapazitive Sensoranordnung, die ein Sensorelement und ein Schildelement umfasst, ist beispielsweise aus der EP 2 112 476 A1 bekannt.

Die kapazitive Erfassung basiert häufig darauf, dass das Sensorelement mittels einer Ladungsübertragung ausgewertet wird. Das Verschieben von elektrischen Ladungen kann jedoch störende Emissionen (Störauswirkungen des Sensorelements auf die Umgebung) bewirken. Ferner können störende Einflüsse aus der Umgebung (Immissionen auf den Sensor) die Erfassung beeinträchtigen.

Darüber hinaus sind auch weitere Störeinflüsse auf die Erfassung bekannt, z. B. störende kapazitive Einwirkungen (parasitäre Kapazitäten, kapazitive Lasten z. B. der Fahrzeugkarossiere, oder dergleichen).

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte kapazitive Erfassung bereitzustellen.

Die voranstehende Aufgabe wird gelöst durch eine Anordnung mit den Merkmalen des unabhängigen Vorrichtungsanspruchs, ein System mit den Merkmalen des unabhängigen Systemanspruchs sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen System sowie dem erfindungsgemäßen Verfahren, und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch eine Anordnung für ein Fahrzeug zur Detektion einer Aktivierungshandlung für die Aktivierung einer Funktion am Fahrzeug.

Hierbei ist insbesondere vorgesehen, dass die Aktivierungshandlung in einem Front-, Seitenund/oder Heckbereich des Fahrzeuges durchgeführt wird, um bei der Detektion der Aktivierungshandlung die Aktivierung der Funktion in der Form einer Öffnung und/oder Entriegelung einer Klappe am Fahrzeug zu initiieren.

Eine erfindungsgemäße Anordnung kann dabei zumindest die nachfolgenden Komponenten aufweisen, welche insbesondere mit einer Leiterplatte der Anordnung verbunden sind:
- wenigstens ein (insbesondere elektrisch leitendes) Sensorelement zur Erfassung einer Veränderung, insbesondere einer Annäherung durch ein Aktivierungsmittel, in einer Umgebung des Sensorelements,
- eine (elektronische) Kontrollanordnung, welche zur elektrischen Ansteuerung des Sensorelements über (wenigstens) einen Kontrollpfad mit dem Sensorelement elektrisch verschaltet ist, um die Erfassung zumindest teilweise bereitzustellen, d. h. zu ermöglichen,
- eine (elektronische) Auswerteanordnung zur wiederholten Ermittlung wenigstens eines für die Erfassung spezifischen Parameters des Sensorelements, um die Detektion der Aktivierungshandlung durchzuführen,
- wenigstens ein (insbesondere elektrisch leitendes) Schildelement, welches zur Abschirmung des Sensorelements benachbart zum Sensorelement angeordnet ist, vorzugsweise im Erfassungsbereich des Sensorelements angeordnet ist,
- eine Schildkontrollanordnung, welche zur Bereitstellung der elektrischen Ansteuerung des Sensorelements für das Schildelement elektrisch mit dem Kontrollpfad und dem Schildelement verbunden ist.

In anderen Worten kann ein elektrisches Ansteuerungssignal, welches für die elektrische Ansteuerung am Kontrollpfad vorliegt, ebenfalls zur Ansteuerung des Schildelements über die Schildkontrollanordnung genutzt werden. Dies ermöglicht eine Abschirmung von Störeinflüssen, insbesondere von kapazitiven Störeinwirkungen auf das Sensorelement, welche besonders zuverlässig an die elektrische Ansteuerung des Sensorelements angepasst ist. Damit kann die Detektion der Aktivierungshandlung deutlich verbessert werden.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges und/oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt.

Es ist ferner denkbar, dass - für die Aktivierung der Funktion am Fahrzeug - durch eine erfindungsgemäße Anordnung eine Aktivierungshandlung detektiert wird. Es kann sich hierbei insbesondere um eine Aktivierungshandlung außerhalb des Fahrzeuges handeln (welche also nicht im Fahrzeuginnenraum stattfindet). In anderen Worten kann die Umgebung des Sensorelements, in welcher die Veränderung erfasst wird, sich außerhalb des Fahrzeuges befinden. Bei erfolgreicher Detektion der Aktivierungshandlung durch die erfindungsgemäße Anordnung kann dabei durch die Anordnung (insbesondere durch eine Kontrollvorrichtung) die Funktion ausgelöst und/oder die Authentifizierung initiiert werden. Bei der Aktivierungshandlung kann es sich z. B. um die Annäherung und/oder die Geste handeln, welche mittels des Aktivierungsmittels durchgeführt wird. Das Aktivierungsmittel bzw. die Aktivierungshandlung kann vorteilhafterweise auch dann detektiert werden, wenn es sich bei dem Aktivierungsmittel um ein nicht-elektronisches Objekt (und damit auch nicht um einen ID-Geber) handelt. Stattdessen kann das Aktivierungsmittel als eine nichtelektrische und/oder nicht-metallische und/oder biologische Substanz ausgeführt sein, wie z. B. ein Körperteil eines Benutzers. Daher ist die Nutzung einer kapazitiven Erfassung zur Detektion der Aktivierungshandlung besonders vorteilhaft, da dies keine besonderen Vorkehrungen am Aktivierungsmittel voraussetzt.

Eine erfindungsgemäße Anordnung ist vorteilhafterweise als eine elektronische Schaltung (Schaltungsanordnung) ausgebildet, und weist elektronische Komponenten auf, welche zumindest teilweise an einer Leiterplatte angeordnet und über elektrische Leiterbahnen miteinander verschaltet sein können. Wenigstens eine dieser Komponenten kann dabei auch als integrierter Schaltkreis ausgebildet sein (wie z. B. eine Kontrollvorrichtung in der Form eines Mikrocontrollers). Auch können einige der Komponenten als SMD (Surface-Mounted-Device) Bauelemente ausgebildet sein. Das Sensorelement kann elektrisch leitend z. B. als Leiterbahn oder als flächige Elektrode an der Leiterplatte ausgebildet sein, oder auch über eine Zuleitung (wie eine elektrische Leitung) mit der Leiterplatte verbunden sein. Im letzteren Fall ist das Sensorelement bspw. Teil eines Kabels (wie eines Koaxialkabels), als eine flächige Elektrode oder als langgestreckter Leiter ausgebildet. Das Sensorelement kann dabei auch als eine kapazitive Antenne aufgefasst werden, da durch das Sensorelement eine veränderliche Sensorkapazität bereitgestellt wird. Ferner kann die veränderliche Sensorkapazität optional auch durch mehrere Sensorelemente bereitgestellt werden, welche gleichzeitig oder abwechselnd betrieben werden. Die Leiterplatte und/oder das Sensorelement ist z. B. in einem Türgriff oder in einem Stoßfänger integriert. Das Sensorelement kann dabei derart angeordnet sein, dass die Anordnung des Sensorelements einen Detektionsbereich für die Aktivierungshandlung definiert.

Es ist bei einer erfindungsgemäßen Anordnung möglich, dass das Sensorelement als eine Sensorelektrode ausgebildet ist, um den für die Erfassung spezifischen Parameter als eine veränderliche Kapazität (auch Sensorkapazität bezeichnet) bereitzustellen, wobei die Veränderung der Kapazität für die Veränderung in der Umgebung des Sensorelements spezifisch sein kann. Wenigstens ein Schildelement kann wiederrum dazu dienen, eine Veränderung in einem abzuschirmenden Bereich der Umgebung vom Sensorelement abzuschirmen, sodass diese Veränderung nicht signifikant zur Veränderung der Kapazität führt.

Darüber hinaus kann es vorgesehen sein, dass für die Ansteuerung des Sensorelements ein Ansteuerungssignal genutzt wird, und für die Auswertung des Sensorelements ein Sensorsignal genutzt wird. Dabei kann das Sensorsignal vom Ansteuerungssignal abhängig sein. Auch kann eine Ladungsübertragung beim Sensorelement vom Ansteuerungssignal abhängig sein, da z. B. eine elektrische Spannung am Sensorelement dem Ansteuerungssignal folgt (bzw. der elektrischen Spannung des Ansteuerungssignals entspricht).

Es kann vorgesehen sein, dass das Sensorsignal und/oder die Ladungsübertragungen beim Sensorelement im Wesentlichen
- dieselbe Frequenz (Arbeitsfrequenz) aufweist, wie das Ansteuerungssignal, und/oder
- dieselbe Signalform aufweist, wie das Ansteuerungssignal, vorzugsweise Sinusform und/oder eine periodische oszillierende Form, und/oder
- eine Frequenz in einem Arbeitsfrequenzbereich aufweist, wobei auch die Frequenz (Arbeitsfrequenz) des Ansteuerungssignals in diesem Arbeitsfrequenzbereich liegt,
- phasengleich bzw. polaritätsgleich ausgeführt ist,
- einen gleichen Gleichspannungs- und/oder Gleichstromoffset (bzw. DC Offset) aufweist,
- ein reduziertes Frequenzspektrum aufweist, welches durch eine Filteranordnung und/oder eine Auswertefilteranordnung angepasst ist.

Ferner ist es denkbar, dass das Sensorsignal zumindest nach (oder durch) eine Filterung einer Auswertefilteranordnung als Wechselstrom (oder Wechselspannung) vorliegt. Es kann eine Filterung durch die Auswertefilteranordnung auch als Bandpassfilterung ausgeführt sein. Dagegen kann eine Filterung des Ansteuerungssignals insbesondere durch die Filteranordnung als Tiefpassfilterung ausgeführt sein, um einen Gleichspannungsanteil beim Ansteuerungssignal beizubehalten.

Ferner kann es möglich sein, dass die Auswertefilteranordnung dazu ausgeführt ist, alternativ oder zusätzlich zur Bandpassfilterung eine Transkonduktanzwandlung des Sensorsignals durchzuführen. Unter einer Transkonduktanzwandlung wird dabei im Rahmen der Erfindung insbesondere verstanden, dass eine elektrische Spannung in einen dazu proportionalen und vorzugsweise gleichen elektrischen Strom umgewandelt wird. Funktional kann dies der Funktion eines Transkonduktanzverstärkers entsprechen, ggf. mit einem Verstärkungsfaktor (Proportionalitätsfaktor) von maximal 1. Jedoch kann im Gegensatz zum Transkonduktanzverstärker die Auswertefilteranordnung keinen Operationsverstärker aufweisen, sondern die Transkonduktanzwandlung mittels des komplexen Widerstands und insbesondere durch die Verschaltung in Serie mit dem virtuellen Nullpunkt erzielen.

Die Frequenz des Sensorsignals (als periodisches Signal) kann dabei abhängig sein von einer Arbeitsfrequenz, d. h. insbesondere der Frequenz des Ansteuerungssignals am Ausgang einer Filteranordnung der Kontrollanordnung. Es kann vorteilhafterweise für die gesamte erfindungsgemäße Anordnung eine einzige Arbeitsfrequenz sowohl für die Ansteuerung als auch für die Auswertung, insbesondere kapazitive Sensorauswertung, des Sensorelements genutzt werden, um die Ansteuerung und Auswertung des Sensorelements mit einem vorgegebenen Arbeitsfrequenzbereich durchzuführen. Hierzu wird insbesondere eine Filterung bei der elektrischen Ansteuerung (durch die Filteranordnung) und bei der Auswertung (durch eine Auswertefilteranordnung) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV (Elektromagnetische Verträglichkeit) Bedingungen (bei Emissionen) und störenden Einwirkungen (bei Immissionen). Auch kann durch die Erzeugung des Ansteuerungssignals und/oder die Anpassung der Signalform und/oder Frequenz des Ansteuerungssignals eine Emission des Sensorelements und eine Störanfälligkeit für Immissionen sehr genau eingestellt werden. Um jedoch diese eingestellten Eigenschaften auch bei der Sensorauswertung nutzen zu können, kann das Sensorsignal ebenfalls entsprechend dem Ansteuerungssignal angepasst sein. Das Sensorsignal kann hierzu spezifisch sein für die Ladungsübertragungen und weist dennoch die eingestellten Eigenschaften auf. Hierzu wird z. B. eine (die) Sensorkontrollanordnung genutzt, welche das Ansteuerungssignal in Abhängigkeit von den Ladungsübertragungen (und damit der Sensorkapazität des Sensorelements) verstärkt als das Sensorsignal ausgibt. Dies ist z. B. durch den Einsatz eines Operationsverstärkers bei der Sensorkontrollanordnung möglich, welcher eine Gegenkopplung mittels eines Kondensators aufweist.

Bevorzugt kann die Speicheranordnung als ein elektronischer Integrator ausgeführt sein, insbesondere um empfangene Ladungen zu akkumulieren. Bevorzugt können mehrere Ladungsübertragungen nach mehreren Auf- und Entladungen des Sensorelements genutzt werden, um die Speicheranordnung aufzuladen.

Gemäß einem weiteren Vorteil kann vorgesehen sein, dass die Schildkontrollanordnung zur elektrischen Zwangsführung des Schildelements einen Operationsverstärker aufweist, welcher den Kontrollpfad mit dem Schildelement verbindet. Dies kann dazu dienen, ein Potential am Schildelement gleich zu einem Potential am Kontrollpfad zu erzeugen. In anderen Worten kann hierbei eine Schildspannung (eines Schildsignals) am Schildelement gleich zu einer Ansteuerungsspannung (eines Ansteuerungssignals oder Ausgangssignals) am Kontrollpfad erzeugt werden. Vorzugsweise ist die Ansteuerungsspannung für die elektrische Spannung am Sensorelement spezifisch und/oder dazu proportional. Die elektrische Zwangsführung kann daher eine Führung im Sinne eines Spannungsfolgers betreffen, bei welcher (an einem Eingang der Schildkontrollanordnung) die Eingangsspannung (Ansteuerungsspannung) gleich oder (proportional) verstärkt einem Ausgang (als die Schildspannung) erzeugt wird. Der Eingang der Schildkontrollanordnung kann durch die Nutzung des Operationsverstärkers hochohmig (mit hohem Eingangswiderstand) ausgeführt sein. Damit kann zur zuverlässigen Abschirmung und bei nur geringer Belastung der Ansteuerungsspannung bzw. der elektrischen Ansteuerung des Sensorelements das Schildelement angesteuert werden.

Es kann ferner möglich sein, dass die Schildkontrollanordnung einen Spannungsfolger ausbildet und/oder eine direkte Gegenkopplung eines Übertragungselements, insbesondere eines Operationsverstärkers der Schildkontrollanordnung, aufweist, sodass vorzugsweise ein elektrisches Potential an dem Schildelement dem elektrischen Potential am Kontrollpfad und insbesondere am Sensorelement folgt. Dies kann auch als eine elektrische Zwangsführung des Schildelements aufgefasst werden. Die direkte Gegenkopplung (also insbesondere die direkte elektrische Verbindung eines Ausgangs mit einem Eingang des Operationsverstärkers) kann dazu führen, dass das Potential am Schildelement identisch dem Potential am Sensorelement und/oder Kontrollpfad folgt. Hierdurch wird die Abschirmung deutlich verbessert.

Zudem ist im Rahmen der Erfindung denkbar, dass die Kontrollanordnung eine Signalgeneratoranordnung aufweist, z. B. in der Form eines elektronischen Signalgenerators, welche für die elektrische Ansteuerung des Sensorelements mit dem Sensorelement elektrisch verschaltet ist, um ein elektrisches Signal zur Aufladung des Sensorelements wiederholt zu erzeugen. Hierzu kann die Signalgeneratoranordnung z. B. ein Ansteuerungssignal erzeugen, welches (ggf. durch eine Filteranordnung gefiltert) an eine Sensorkontrollanordnung weitergeleitet wird. Die Sensorkontrollanordnung kann (wie die Schildkontrollanordnung) eine Übertragungsanordnung wie einen Spannungsfolger ausbilden, um ein zum Ansteuerungssignal gleiches Ausgangssignal am Sensorelement zu erzeugen. Dieses Ausgangssignal kann Ladungsübertragungen am Sensorelement bewirken. Hierzu ist das Ansteuerungssignal (und damit auch das Ausgangssignal) vorteilhafterweise als periodisches Signal, insbesondere Sinussignal, ausgeführt. Auf diese Weise kann eine Arbeitsfrequenz bereitgestellt werden, welche der Frequenz des Signals entspricht. Die Arbeitsfrequenz definiert das Störspektrum von Emissionen des Sensorelements. Durch die Schildkontrollanordnung kann diese Arbeitsfrequenz auch für das Schildelement genutzt werden.

Nach einer weiteren Möglichkeit kann vorgesehen sein, dass das Sensorelement als eine Sensorelektrode ausgebildet ist, um den für die Erfassung spezifischen Parameter als eine veränderliche Kapazität (Sensorkapazität) bereitzustellen. Dabei kann die Veränderung der Kapazität für die Veränderung in der Umgebung spezifisch sein. Hierbei kann die Kontrollanordnung dazu ausgeführt sein, zur wiederholten Ermittlung wiederholt eine Ladungsübertragung zwischen dem Sensorelement und einer Sensorkontrollanordnung zu initiieren. Hierzu wird bspw. ein Ansteuerungssignal genutzt, um ein Ausgangssignal zu erzeugen, welches die Ladungsübertragung initiiert. Ferner kann in Abhängigkeit von der Ladungsübertragung eine Speicheranordnung, insbesondere ein Integrator, der Auswerteanordnung aufgeladen werden, sodass vorzugsweise die durch die Speicheranordnung gespeicherte elektrische Ladung für die Veränderung der Kapazität spezifisch ist. Dies ermöglicht eine einfache Detektion der Aktivierungshandlung anhand der Speicheranordnung. Die Aufladung in Abhängigkeit von der Ladungsübertragung kann dabei z. B. dadurch ermöglicht werden, dass die Sensorkontrollanordnung ein Sensorsignal abhängig von der Ladungsübertragung bereitstellt, welches wiederum eine Ladungsübertragung an die Speicheranordnung bewirken kann.

Es ist ferner denkbar, dass eine Sensorkontrollanordnung über einen ersten Anschluss mit dem Sensorelement zur Ladungsübertragung elektrisch verschaltet ist, und eine elektronische Verstärkeranordnung aufweist, um an einem zweiten Anschluss ein Sensorsignal anhand der Ladungsübertragung bereitzustellen, sodass das Sensorsignal spezifisch ist für eine veränderliche Kapazität des Sensorelements. Vorzugsweise kann dabei eine Speicheranordnung der Auswerteanordnung mit der Sensorkontrollanordnung über den zweiten Anschluss verschaltet sein, um durch das Sensorsignal eine Ladungsakkumulation bei der Speicheranordnung durchzuführen, sodass die durch die Speicheranordnung gespeicherte elektrische Ladung für die Veränderung der Kapazität spezifisch ist.

Alternativ oder zusätzlich kann es möglich sein, dass eine Kontrollvorrichtung mit einer/der Speicheranordnung der Auswerteanordnung verschaltet ist, um eine durch die Speicheranordnung gespeicherte elektrische Ladung zur Ermittlung des für die Erfassung spezifischen Parameters auszuwerten, vorzugsweise durch eine Analog-Digital-Umwandlung einer Spannung bei der Speicheranordnung. Hierzu ist die Kontrollvorrichtung bspw. als Mikrocontroller mit einem Analog-Digital-Wandler ausgeführt. Dies ermöglicht eine Detektion der Aktivierungshandlung anhand der Spannung bei der Speicheranordnung. Insbesondere ein zeitlicher Verlauf der Spannung (und damit Veränderungen des Parameters bzw. der Sensorkapazität) können die Detektion ermöglichen.

Bevorzugt kann im Rahmen der Erfindung vorgesehen sein, dass die Kontrollanordnung eine Filteranordnung, insbesondere ein aktives Filter und/oder ein Tiefpassfilter, aufweist, um ein elektrisches Signal (Ansteuerungssignal) zur elektrischen Ansteuerung des Sensorelements über den Kontrollpfad gefiltert, insbesondere tiefpassgefiltert, und/oder geformt bereitzustellen, sodass vorzugsweise eine Emission des Sensorelements durch die Filteranordnung angepasst ist. Damit können Störauswirkungen in die Umgebung reduziert und/oder zuverlässig vorgegeben werden. Die Tiefpassfilterung kann vorteilhaft sein, um einen Gleichanteil des elektrischen Signals beizubehalten.

Weiter ist im Rahmen der Erfindung denkbar, dass die Kontrollanordnung eine Filteranordnung, insbesondere ein aktives Filter, aufweist, welches eine Signalgeneratoranordnung mit dem Kontrollpfad verbindet, um insbesondere ein durch die Signalgeneratoranordnung erzeugtes elektrisches Signal (Ansteuerungssignal) am Kontrollpfad gefiltert, insbesondere tiefpassgefiltert, und/oder geformt bereitzustellen, und dadurch als ein gefiltertes elektrisches Signal, vorzugsweise Sinussignal, bereitzustellen. Somit lässt sich die Emission durch den Sensor zuverlässig beeinflussen.

Zudem ist im Rahmen der Erfindung denkbar, dass die Schildkontrollanordnung unmittelbar mit dem Sensorelement und/oder einem elektrischen Potential am Sensorelement elektrisch verbunden ist, um ein elektrisches Potential am Schildelement unmittelbar an ein elektrisches Potential am Sensorelement anzugleichen. Dies ermöglicht eine besonders exakte Angleichung der elektrischen Potentiale zwischen Sensorelement und Schildelement, um eine aktive Abschirmung bereitzustellen.

Ferner ist es optional vorgesehen, dass die Schildkontrollanordnung nur indirekt mit dem Sensorelement, bevorzugt über eine Sensorkontrollanordnung und/oder über ein Schaltelement, elektrisch verbunden ist. Damit kann ggf. eine Beeinflussung des Sensorelements durch die Anbindung der Schildkontrollanordnung weiter reduziert werden.

Es ist außerdem möglich, dass der Kontrollpfad über eine Sensorkontrollanordnung und/oder über ein Schaltelement mit dem Sensorelement elektrisch verbunden ist, sodass über das Schaltelement verschiedene Sensorelemente mit dem Kontrollpfad verbunden werden können. Es können entsprechend mindestens zwei oder mindestens drei Sensorelemente vorgesehen sein, welche abwechselnd über das Schaltelement mit der Sensorkontrollanordnung verbunden werden. Auf diese Weise kann der Detektionsbereich vergrößert oder angepasst werden.

Vorteilhafterweise kann bei der Erfindung vorgesehen sein, dass eine Sensorkontrollanordnung über einen ersten Anschluss mit dem Sensorelement verschaltet ist, und/oder über einen zweiten Anschluss mit der Auswerteanordnung verschaltet ist, und/oder über einen dritten Anschluss mit einer Signalgeneratoranordnung und/oder einer Filteranordnung verschaltet ist, und insbesondere eine Übertragungsanordnung, vorzugsweise einen Spannungsfolger und/oder Spannungsvervielfacher, aufweist, um ein elektrisches Potential an dem dritten Anschluss in gleicher oder verstärkter Weise über den ersten Anschluss am Sensorelement zu erzeugen, und/oder in gleicher oder verstärkter Weise über den zweiten Anschluss an der Auswerteanordnung zur Ermittlung zu erzeugen, bevorzugt sodass das elektrische Potential am Sensorelement und/oder das elektrische Potential am zweiten Anschluss dem elektrischen Potential am dritten Anschluss folgt. Somit kann eine Art "Entkopplung" durch die Sensorkontrollanordnung stattfinden, bei welcher die Sensorkontrollanordnung als eine gesteuerte Spannungsquelle aufgefasst werden kann. Anhand des Ansteuerungssignals kann dabei eine Spannung am Sensorelement erzeugt werden, um die Ladungsübertragung zu bewirken. Anhand des Ansteuerungssignals und insbesondere der Ladungsübertragung kann ferner ein Sensorsignal erzeugt werden, um den Parameter anhand des Sensorsignals auszuwerten. Dabei kann durch die "Entkopplung" eine Belastung der elektrischen Ansteuerung des Sensorelements reduziert werden.

Es kann weiter möglich sein, dass die Schildkontrollanordnung und eine Sensorkontrollanordnung mit einer gleichen Signalgeneratoranordnung und/oder gleichen Filteranordnung elektrisch verschaltet sind, um ein durch die Signalgeneratoranordnung erzeugtes und/oder durch die Filteranordnung gefiltertes elektrisches Signal (Ansteuerungssignal) sowohl an das Sensorelement als auch an das Schildelement zu übertragen, z. B. auch über eine Sensorkontrollanordnung und/oder Schildkontrollanordnung, vorzugsweise mit einer im Wesentlichen identischen Signalform des Signals, vorzugsweise einer zumindest annähernden Sinusform, sodass eine elektrische Potentialdifferenz zwischen dem Sensorelement und dem Schildelement im Betrieb der Anordnung während der Ansteuerung und/oder Erfassung stets minimiert wird. Damit kann die Abschirmung deutlich verbessert werden.

Ferner kann im Rahmen der Erfindung vorgesehen sein, dass das Schildelement als aktives Schildelement ausgeführt ist, sodass mittels der Schildkontrollanordnung ein elektrisches Potential am Schildelement dem elektrischen Potential an dem Sensorelement aktiv nachgeführt wird. Dies kann z. B. durch die Kopplung des Schildelements über die Schildkontrollanordnung mit dem Kontrollpfad ermöglicht werden.

Ein weiterer Vorteil im Rahmen der Erfindung ist erzielbar, wenn die Anordnung als kapazitive Sensoranordnung zumindest teilweise in einem Stoßfänger des Fahrzeuges integriert ist, um den Heckbereich des Fahrzeuges zu überwachen, und um als die Funktion am Fahrzeug die Heckklappe (und/oder Frontklappe und/oder Schiebetür an einer Seite) des Fahrzeuges zu öffnen, insbesondere um eine Ausgabe eines Öffnungssignals und/oder eine Authentifizierungsprüfung zu initiieren. Damit ist ein komfortabler Zugang zum Fahrzeug ermöglicht.

Des Weiteren ist es im Rahmen der Erfindung optional möglich, dass die Anordnung eine Sensorkontrollanordnung aufweist, um wiederholt durch die elektrische Ansteuerung des Sensorelements eine elektrische Ladung zwischen der Sensorkontrollanordnung und dem Sensorelement zu übertragen, und um zur Ermittlung des wenigstens einen für die Erfassung spezifischen Parameters des Sensorelements eine Speicheranordnung in Abhängigkeit von einer Ladungsmenge im Sensorelement aufzuladen, wobei eine Kontrollvorrichtung, insbesondere wenigstens ein Mikrocontroller, mit der Speicheranordnung elektrisch verbunden ist, um nach der Aufladung die Menge der in der Speicheranordnung gespeicherten und/oder nach mehreren Aufladungen akkumulierten Ladung auszuwerten, und anhand der Auswertung die Detektion durchzuführen, vorzugsweise um ein Aktivierungssignal zur Aktivierung der Funktion am Fahrzeug auszugeben, wenn die gespeicherte und/oder akkumulierte Ladung der Speicheranordnung einen Grenzwert überschreitet. Somit ist eine besonders zuverlässige Möglichkeit zur Detektion der Aktivierungshandlung bereitgestellt.

Bevorzugt kann im Rahmen der Erfindung vorgesehen sein, dass das Schildelement eine U-Form aufweist, mit einem Mittenteil zur Abschirmung im Mittenbereich und einem Seitenteil zur seitlichen Abschirmung des Sensorelements. Somit wird die Abschirmung am Sensorelement deutlich verbessert.

Weiter ist im Rahmen der Erfindung denkbar, dass das Sensorelement über eine Sensorzuleitung mit der Kontrollanordnung verschaltet ist, wobei die Sensorzuleitung mit einem weiteren Schildelement, jeweils in der Form eines elektrischen Kabels, verdrillt ist, wobei vorzugsweise das weitere Schildelement als ein passives oder aktives Schildelement betrieben wird, insbesondere unabhängig vom Potential des Sensorelements auf ein festes elektrisches Potential gelegt ist. Somit können Störeinflüsse im Bereich der Zuleitung verringert werden.

Bspw. kann es vorgesehen sein, dass das Sensorelement über eine Sensorzuleitung mit der Kontrollanordnung verschaltet ist, wobei die Sensorzuleitung als Innenleiter eines Koaxialkabels ausgebildet ist, wobei ein Außenleiter des Koaxialkabels als das Schildelement, insbesondere aktives Schildelement, ausgebildet ist. Dies ermöglicht eine besonders einfache und zuverlässige Montage und Verlegung des Sensor- und Schildelements.

Ebenfalls Gegenstand der Erfindung ist ein System aufweisend:
- eine erfindungsgemäße Anordnung,
- eine Kontrollvorrichtung zur Ausgabe eines Aktivierungssignals im Falle der Detektion der Aktivierungshandlung (durch die erfindungsgemäße Anordnung, wobei die Kontrollvorrichtung hierzu mit der erfindungsgemäßen Anordnung in signaltechnischer Verbindung steht),
- ein Steuergerät, welches mit der Kontrollvorrichtung (insbesondere signaltechnisch) verbunden ist, um bei Empfang des Aktivierungssignals die Funktion am Fahrzeug auszuführen.

Damit bringt das erfindungsgemäße System die gleichen Vorteile mit sich, wie sie ausführlich mit Bezug auf eine erfindungsgemäße Anordnung beschrieben worden sind.

Ebenfalls Gegenstand der Erfindung ist ein Verfahren für ein Fahrzeug zur Detektion einer Aktivierungshandlung für die Aktivierung einer Funktion am Fahrzeug, insbesondere in einem Front-, Seiten- und/oder Heckbereich des Fahrzeuges für die Aktivierung einer Öffnung und/oder Entriegelung einer Klappe am Fahrzeug.

Hierbei ist vorgesehen, dass die nachfolgenden Schritte durchgeführt werden, vorzugsweise nacheinander in der angegebenen oder in beliebiger Reihenfolge, wobei die Schritte ggf. auch zumindest teilweise zeitlich parallel und/oder synchronisiert und/oder wiederholt durchgeführt werden können:
- Ansteuern eines Sensorelements durch eine elektrische Ansteuerung über einen Kontrollpfad, um eine Erfassung einer Veränderung, insbesondere einer Annäherung durch ein Aktivierungsmittel, in einer Umgebung des Sensorelements bereitzustellen,
- Ermitteln wenigstens eines für die Erfassung spezifischen Parameters des Sensorelements, um die Detektion der Aktivierungshandlung durchzuführen,
- Bereitstellen, insbesondere zumindest teilweise gleichzeitig zum Ansteuern des Sensorelements, der elektrischen Ansteuerung über den Kontrollpfad für ein Schildelement, welches zur Abschirmung des Sensorelements benachbart zum Sensorelement angeordnet ist.

Damit bringt das erfindungsgemäße Verfahren die gleichen Vorteile mit sich, wie sie ausführlich mit Bezug auf eine erfindungsgemäße Anordnung beschrieben worden sind. Zudem kann das Verfahren geeignet sein, eine erfindungsgemäße Anordnung zu betreiben.

Des Weiteren kann vorgesehen sein, dass das Ansteuern des Sensorelements den nachfolgenden Schritt aufweist:
- Anlegen eines elektrischen Potentials am Sensorelement gemäß der elektrischen Ansteuerung, vorzugsweise durch ein elektrisches Signal mit einer vorgegebener insbesondere oszillierenden Signalform, vorzugsweise einer zumindest annähernden Sinusform, welches durch eine Filteranordnung und/oder eine Signalgeneratoranordnung ausgegeben wird, um eine Aufladung des und/oder eine Ladungsübertragung zum Sensorelement durchzuführen.

Damit kann ein Spektrum von störenden Emissionen des Sensorelements deutlich reduziert werden.

Es ist ferner denkbar, dass das Ermitteln des wenigstens einen für die Erfassung spezifischen Parameters des Sensorelements den nachfolgenden Schritt aufweist:
- Initiieren einer Ladungsübertragung zwischen dem Sensorelement und einer Sensorkontrollanordnung, vorzugsweise durch ein elektrisches Signal gemäß der elektrischen Ansteuerung, um anhand der übertragenen Ladung den Parameter, vorzugsweise eine durch das Sensorelement bereitgestellte veränderliche Kapazität, zu ermitteln.

Dies ermöglicht eine zuverlässige kapazitive Detektion, da die übertragene Ladung abhängig ist von dem Parameter, wie der veränderlichen Kapazität.

Vorteilhaft ist es darüber hinaus, wenn im Rahmen der Erfindung das Bereitstellen der elektrischen Ansteuerung über den Kontrollpfad für ein Schildelement den nachfolgenden Schritt aufweist:
- Anlegen eines elektrischen Potentials am Schildelement in Abhängigkeit von einem elektrischen Potential am Sensorelement und/oder einem elektrischen Signal gemäß der elektrischen Ansteuerung, vorzugsweise eines elektrischen Signals mit einer vorgegebener Signalform, vorzugsweise einer oszillierenden und/oder zumindest annähernden Sinusform, welches durch eine Filteranordnung und/oder eine Signalgeneratoranordnung ausgegeben wird, um eine Aufladung des und/oder eine Ladungsübertragung zum Sensorelement durchzuführen.

Somit kann die elektrische Abschirmung des Sensorelements verbessert werden, die Bereitstellung der gleichen Frequenz und Amplitude des Signals für die Abschirmung gewährleistet wird.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine schematische Ansicht auf einen Heckbereich eines Fahrzeuges mit einer erfindungsgemäßen Anordnung und einem erfindungsgemäßen System,
- Figur 2: eine schematische Seitenansicht eines Fahrzeuges mit einer erfindungsgemäßen Anordnung und einem erfindungsgemäßen System,
- Figur 3: ein schematisches Schaltbild von Teilen einer erfindungsgemäßen Anordnung,
- Figur 4: ein schematisches Schaltbild von Teilen einer erfindungsgemäßen Anordnung,
- Figur 5: eine schematische Darstellung von Teilen einer erfindungsgemäßen Anordnung bzw. eines erfindungsgemäßen Systems,
- Figur 6: eine schematische Darstellung von Teilen einer erfindungsgemäßen Anordnung bzw. eines erfindungsgemäßen Systems, und
- Figur 7: eine schematische Darstellung zur Visualisierung eines erfindungsgemäßen Systems.

In den nachfolgenden Figuren werden für die gleichen technischen Merkmale auch von unterschiedlichen Ausführungsbeispielen die identischen Bezugszeichen verwendet.

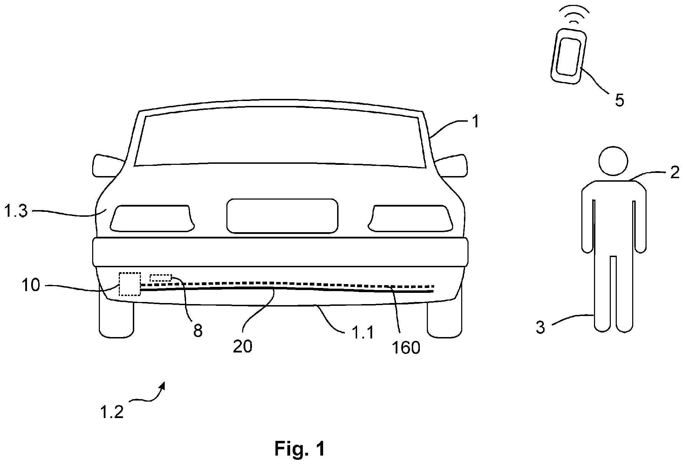

In Figur 1 ist eine Ansicht auf einen Heckbereich 1.2 eines Fahrzeuges 1 mit einem erfindungsgemäßen System gezeigt. Eine erfindungsgemäße Anordnung 10 kann in einem Stoßfänger 1.1 des Fahrzeuges 1 integriert sein, um eine Aktivierungshandlung durch ein Aktivierungsmittel 3 (wie ein Bein 3) eines Benutzers 2 im Bereich des Stoßfängers 1.1 zu detektieren. Hierzu weist die Anordnung 10 ein Sensorelement 20 auf, welches bspw. als langgestreckte und/oder kabelförmige Elektrode 20 oder als flächige Elektrode 20 (d. h. Flachelektrode) oder als kapazitive Antenne ausgebildet sein kann. Es ist ferner möglich, dass ein Kabel, wie ein Koaxialkabel, zur Ausbildung des Sensorelements 20 genutzt wird. Eine Detektion der Aktivierungshandlung kann dazu führen, dass eine Heckklappe 1.3 des Fahrzeuges 1 geöffnet wird. Zu diesem Zweck kann die Anordnung 10 eine Signalverbindung mit einem Steuergerät 8 des Fahrzeuges 1 aufweisen, um über die Signalverbindung ein Aktivierungssignal an das Steuergerät 8 auszugeben, welches die Öffnung der Heckklappe 1.3 initiiert. Vorausgesetzt werden kann für die Öffnung ggf. eine erfolgreiche Authentifizierung mit einem Identifikationsgeber 5. In gleicher Weise kann ggf. auch eine Klappe, insbesondere Tür 1.6, im Frontbereich 1.7 und/oder im Seitenbereich 1.4 des Fahrzeuges durch eine erfindungsgemäße Anordnung 10 aktiviert werden, wobei die Anordnung 10 dann z. B. im Türgriff 1.5 oder ebenfalls im Stoßfänger 1.1 oder an einem Seitenschweller integriert ist.

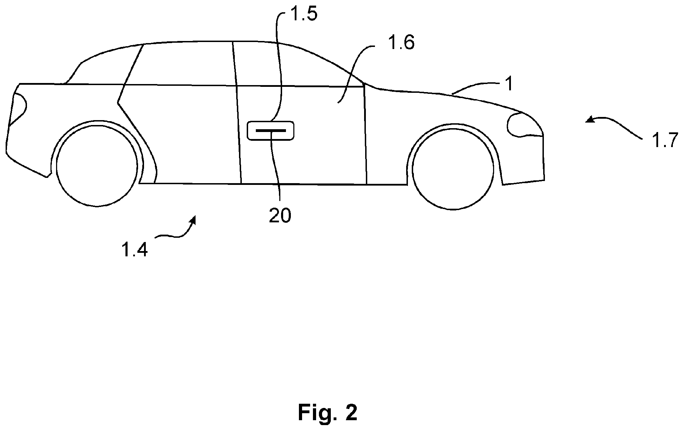

In Figur 2 ist schematisch ein Fahrzeug 1 in einer Seitenansicht gezeigt. Der Seitenbereich 1.4 und/oder der Frontbereich 1.7 des Fahrzeuges 1 kann alternativ oder zusätzlich zum Heckbereich 1.2 eine erfindungsgemäße Anordnung 10 aufweisen. Bspw. ist das Sensorelement 20 im Seitenbereich 1.4 in einen Türgriff 1.5 des Fahrzeuges integriert, um die Aktivierungshandlung im Bereich des Türgriffes 1.5 zu detektieren. So kann bspw. als eine Aktivierungshandlung eine Annäherung an das Sensorelement 20 durch die Anordnung 10 im Seitenbereich 1.4 detektiert werden. Diese Aktivierungshandlung kann ein Hineingreifen eines Aktivierungsmittels 3 (wie einer Hand) in eine Türgriffmulde des Türgriffs 1.5 umfassen. Die Anordnung des Sensorelements 20 im Frontbereich 1.7 kann wiederum im Stoßfänger 1.1 vorgesehen sein, um z. B. bei der Detektion der Aktivierungshandlung im Frontbereich 1.7 eine Frontklappe zu öffnen. Eine weitere mögliche Funktion, welche durch eine Aktivierungshandlung aktivierbar ist, kann die Öffnung von Schiebetüren 1.6 des Fahrzeuges 1 sein, z. B. durch Annäherung an einen Seitenschweller des Fahrzeuges.

Grundsätzlich kann die Aktivierungshandlung eine Annäherung an das Sensorelement 20 oder auch eine Geste oder dergleichen umfassen. Insbesondere zur Detektion von Gesten kann neben einem einzigen Sensorelement 20 noch wenigstens ein weiteres Sensorelement 20' vorgesehen sein, und benachbart zum Sensorelement 20 angeordnet sein. Dies ermöglicht es, eine Bewegung des Aktivierungsmittels durch die unterschiedliche Erfassung der Sensorelemente 20, 20' zu erkennen. Ebenfalls kann benachbart zum Sensorelement 20 und/oder weiteren Sensorelement 20' ein Schildelement 160 zur Abschirmung angeordnet sein. In Figur 1 ist beispielhaft diese Anordnung im Stoßfänger 1.1 gezeigt.

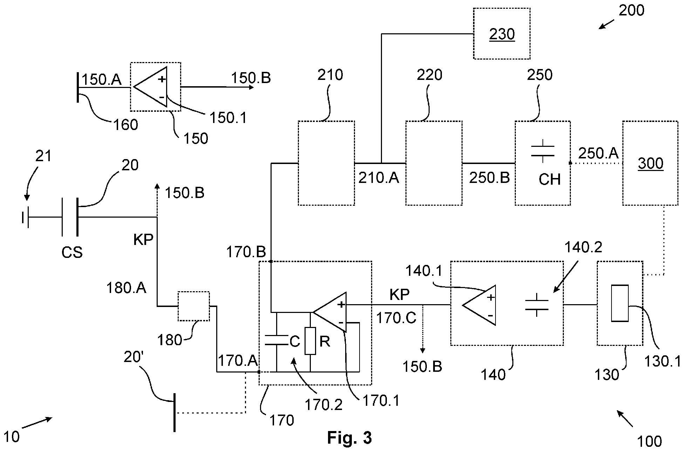

In Figur 3 ist eine erfindungsgemäße Anordnung 10 für ein Fahrzeug 1 gezeigt, welche zur Detektion einer Aktivierungshandlung für die Aktivierung einer Funktion am Fahrzeug 1, insbesondere wie gemäß Figur 1 und 2 beschrieben zur Detektion der Aktivierungshandlung in einem Front-, Seiten- und/oder Heckbereich 1.7, 1.4, 1.2 des Fahrzeuges 1 für die Aktivierung einer Öffnung und/oder Entriegelung einer Klappe 1.3, 1.6, insbesondere Tür 1.6, am Fahrzeug 1, dient.

Die erfindungsgemäße Anordnung 10 kann wenigstens ein Sensorelement 20 zur Erfassung einer Veränderung in einer Umgebung des Sensorelements 20 aufweisen. Diese Veränderung ist bspw. durch die Aktivierungshandlung bedingt, bspw. eine Annäherung durch ein Aktivierungsmittel 3. Das Sensorelement 20 kann dabei als ein elektrischer Leiter, wie eine elektrisch leitfähige Fläche (insbesondere bei einer Montage der Anordnung 10 im Türgriff 1.5) oder eine langgestreckte und ggf. flächige Elektrode (insbesondere bei einer Montage im Stoßfänger 1.1) ausgebildet sein.

Die Sensitivität des Sensorelements 20 für Veränderungen in der Umgebung und damit für die Aktivierungshandlung kann bspw. wie folgt vereinfacht erklärt werden. Gegenüber der Umgebung und/oder einem Massepotential 21 kann das Sensorelement 20 eine Kapazität (im Folgenden auch als Sensorkapazität CS bezeichnet) ausbilden. Durch die Erzeugung eines elektrischen Potentials (mittels einer nachfolgend beschriebenen elektrischen Ansteuerung) an dem Sensorelement 20 kann ein elektrisches Feld in der Umgebung entstehen. Die Sensorkapazität CS wird durch die Veränderung in der Umgebung beeinflusst und ist somit veränderlich. In anderen Worten korreliert die Veränderung der Sensorkapazität CS mit der Veränderung in der Umgebung, d. h. dem Vorliegen einer Aktivierungshandlung. Eine Auswertung der veränderlichen Kapazität CS kann insbesondere durch eine Auswertung der im Sensorelement 20 gespeicherten Ladungsmenge erfolgen und Rückschlüsse auf die Veränderung in der Umgebung bieten, und somit zur Detektion der Aktivierungshandlung dienen. Somit ist insbesondere die Durchführung von Ladungsübertragungen von und zu dem Sensorelement 20 geeignet, anhand der Ladungsübertragungen (wie der übertragenen Ladungsmenge und/oder der dabei erfassbaren Stromstärke und/oder Spannung) ein Sensorsignal bereitzustellen, welches für die Bestimmung der veränderlichen Kapazität CS ausgewertet werden kann.

Um die elektrische Ansteuerung durchzuführen, kann eine Kontrollanordnung 100 (im Sinne einer Steuerungsanordnung 100) genutzt werden. Die Kontrollanordnung 100 kann zur elektrischen Ansteuerung des Sensorelements 20 über einen Kontrollpfad KP mit dem Sensorelement 20 elektrisch verschaltet sein, um die Erfassung bereitzustellen (d. h. zu ermöglichen). Durch die elektrische Ansteuerung kann z. B. eine (zwangsgeführte) Auf- und Entladung des Sensorelements 20 über Ladungsübertragungen initiiert werden, um anhand dieser Ansteuerung des Sensorelements 20 die kapazitive Erfassung zu erlauben. Die elektrische Verschaltung kann z. B. mittels einer elektrischen Verbindung über Leiterbahnen einer Leiterplatte realisiert werden. Die erfindungsgemäße Anordnung 10 kann zumindest teilweise an dieser Leiterplatte als elektrische Schaltung angeordnet sein. Das Sensorelement 20 und/oder das weitere Sensorelement 20' und/oder das wenigstens eine Schildelement 160 kann dabei über einen elektrischen Anschluss der Leiterplatte mit der Kontrollanordnung 100 der Anordnung 10 über Leiterbahnen elektrisch verbunden sein, oder auch selbst als Leiterbahn ausgebildet sein. Die Erfassung wird bspw. dadurch bereitgestellt, dass ein elektrisches Potential durch die Kontrollanordnung 100 am Sensorelement 20 erzeugt wird, um das Sensorelement 20 aufzuladen, und damit wie zuvor beschrieben z. B. die Auswertung der veränderlichen Kapazität CS ermöglicht. Es kann sich dabei auch um ein wechselndes Potential handeln, sodass eine elektrische Spannung am Sensorelement 20 z. B. als periodische und/oder sinusförmige Spannung erzeugt wird. Zur Auswertung des Sensorelements 20 ist eine Auswerteanordnung 200 vorgesehen, welche eine wiederholte Ermittlung wenigstens eines für die Erfassung spezifischen Parameters des Sensorelements 20 durchführt, um die Detektion der Aktivierungshandlung durchzuführen. Im konkret beschriebenen Beispiel wird die veränderliche Kapazität CS als dieser Parameter angesehen.

Darüber hinaus ist es möglich, dass wenigstens ein Schildelement 160 vorgesehen ist, welches zur Abschirmung des Sensorelements 20 benachbart (und damit im Wirkbereich) zum Sensorelement 20 angeordnet ist. Um eine Abschirmung durch das Schildelement 160 zu ermöglichen, ist eine Schildkontrollanordnung 150 mit einem Anschluss 150.A für das Schildelement 160 vorgesehen. Die Schildkontrollanordnung 150 kann über einen Schildkontrolleingang 150.B zur Bereitstellung der (zuvor beschriebenen) elektrischen Ansteuerung der Kontrollanordnung 100 für das Schildelement 160 elektrisch mit dem Kontrollpfad KP und somit auch mit dem Schildelement 160 verbunden sein. In anderen Worten kann die Schildkontrollanordnung 150 die gleiche elektrische Ansteuerung für das Schildelement 160 bereitstellen, welche auch für das Sensorelement 20 genutzt wird. Hierzu folgt eine elektrische Ausgangsspannung an dem Ausgang 150.A der Schildkontrollanordnung 150, welcher elektrisch mit dem Schildelement 160 verbunden ist, einer Eingangsspannung an dem Eingang 150.B der Schildkontrollanordnung 150, welcher wiederrum elektrisch mit dem Kontrollpfad KP verbunden und damit auch mit dem Sensorelement 20 verschaltet ist. Für das Sensorelement 20 und für das Schildelement 160 kann auf diese Weise ein gleiches Ansteuerungssignal genutzt werden, um durch das Ansteuerungssignal das Potential am Sensorelement 20 und am Schildelement 160 in gleicher Weise einzustellen.

Zur Verbindung der Schildkontrollanordnung 150 mit dem Kontrollpfad KP kann ein Verbindungspunkt am Kontrollpfad KP genutzt werden. Hierzu kommen verschiedene Positionen am Kontrollpfad KP in Frage, z. B. unmittelbar am Strompfad zum Sensorelement 20 oder zwischen einer Filteranordnung 140 und einer Sensorkontrollanordnung 170. In Figur 3 sind beispielhaft und nicht abschließend mit gestrichelter Linie zwei mögliche Verbindungspunkte des Schildkontrolleingangs 150.B mit der Schildkontrollanordnung 150 gezeigt. Bei Verwendung des Verbindungspunkts am Anschluss 170.C der Sensorkontrollanordnung 170 kann zur Einstellung des Potentials am Schildelement 160 das Ansteuerungssignal genutzt werden, welches durch die Filteranordnung 140 ausgegeben wird. Bei der Verwendung des Verbindungspunkts unmittelbar am Strompfad zum Sensorelement 20 wird zur Einstellung des Potentials am Schildelement 160 das (im Wesentlichen) gleiche Potential genutzt, welches am Sensorelement 20 anliegt.

Um die elektrische Ansteuerung besonders zuverlässig anzugleichen, und insbesondere dabei die Komponenten am Verbindungspunkt (wie das Sensorelement 20 bzw. die Kontrollanordnung 100) nicht übermäßig zu belasten, kann die Schildkontrollanordnung 150 zur elektrischen Zwangsführung des Schildelements 160 einen Operationsverstärker 150.1 aufweisen. Dieser kann genutzt werden, um den Kontrollpfad KP mit dem Schildelement 160 zu verbinden, und so die Ausgangsspannung (auch bezeichnet als Schildspannung) am Schildelement 160 gleich zur Eingangsspannung am Kontrollpfad KP zu erzeugen. Die Eingangsspannung entspricht dabei einer Ansteuerungsspannung, welche für die elektrische Spannung am Sensorelement 20 spezifisch und/oder dazu proportional ist. Bevorzugt kann die Schildkontrollanordnung 150 einen Spannungsfolger ausbilden, sodass ein elektrisches Potential an dem Schildelement 160 dem elektrischen Potential am Kontrollpfad KP und insbesondere am Sensorelement 20 folgt. Es kann entsprechend eine direkte Gegenkopplung des Operationsverstärkers 150.1 vorgesehen sein, um einen Verstärkungsfaktor von 1 zu erhalten. Der Schildkontrolleingang 150.B kann dabei (direkt) mit dem positiven (nicht invertierenden hochohmigen) Eingang des Operationsverstärkers 150.1 elektrisch verbunden sein, sodass der Eingangswiderstand des Schildkontrolleingangs 150.B sehr groß ist, um die Spannung am Schildkontrolleingangs 150.B nur gering zu belasten. Der Schildelementanschluss 150.A kann hingegen mit dem Ausgang des Operationsverstärkers 150.1 und aufgrund der Gegenkopplung ggf. auch mit dem invertierenden Eingang des Operationsverstärkers 150.1 (direkt) elektrisch verbunden sein, um einen im Vergleich zum Eingangswiderstand niederohmigen Ausgang bereitzustellen.

Ferner ist anhand Figur 3 erkennbar, dass die Kontrollanordnung 100 eine Signalgeneratoranordnung 130 aufweist, welche für die elektrische Ansteuerung des Sensorelements 20 mit dem Sensorelement 20 elektrisch verschaltet ist, um ein elektrisches Signal zur Aufladung des Sensorelements 20 wiederholt zu erzeugen. Dieses elektrische Signal, nachfolgend auch als Ansteuerungssignal bezeichnet, kann zur beschriebenen elektrischen Ansteuerung dienen, und damit für das Sensorelement 20, ggf. auch für das weitere Sensorelement 20', und insbesondere auch für das wenigstens eine Schildelement 160 zur Einstellung des elektrischen Potentials und/oder zur elektrischen Auf- und Entladung bereitgestellt werden. Diese Bereitstellung erfolgt z. B. durch die Übertragung des elektrischen Signals über zumindest einen Teil des Kontrollpfads KP an eine Sensorkontrollanordnung 170 und/oder an eine Schildkontrollanordnung 150. Die Erzeugung des Ansteuerungssignals durch die Signalgeneratoranordnung 130 bewirkt somit, dass das Ansteuerungssignal (ggf. zuvor verändert, insbesondere gefiltert) am Anschluss 170.C vorliegt. Durch die Sensorkontrollanordnung 170 und/oder Schildkontrollanordnung 150 kann wiederum anhand des Ansteuerungssignals das Sensorelement 20, das weitere Sensorelement 20' und/oder das Schildelement 160 angesteuert werden. Hierzu wird anhand des Ansteuerungssignals eine Ladungsübertragung (Auf- und/oder Entladung) bei dem Sensorelement 20 bzw. das weitere Sensorelement 20' und/oder das Schildelement 160 initiiert (und damit auch die Entstehung eines elektrischen Feldes initiiert). Die Auswertung der Menge der übertragenen Ladung kann eine Auswertung der veränderlichen Sensorkapazität CS ermöglichen. Der zeitliche Verlauf dieser Ladungsübertragung kann durch die Formung des elektrischen Signals beeinflusst werden. Hierzu weist die Signalgeneratoranordnung 130 z. B. einen Digital-Analog-Konverter 130.1 auf, welcher auch als Teil einer Kontrollvorrichtung 300 wie eines Mikrocontrollers ausgeführt sein kann. Auch kann die Signalgeneratoranordnung 130 ggf. vollständig Teil der Kontrollvorrichtung 300 sein. Auch ist es denkbar, dass die Signalgeneratoranordnung 130 nur teilweise in die Kontrollvorrichtung 300 integriert ist, und z. B. der Digital-Analog-Konverter 130.1 separat davon ausgebildet ist. Damit kann sehr zuverlässig und genau eine bestimmte Signalform des Ansteuerungssignals bestimmt werden. Diese Signalform kann durch eine anschließende Filterung ggf. weiter geformt und/oder verbessert werden, sodass das Ansteuerungssignal anschließend bspw. eine Sinusform gemäß einer Arbeitsfrequenz aufweist. Daher kann die Kontrollanordnung 100 eine Filteranordnung 140, insbesondere ein aktives Filter 140 z. B. ein Tiefpassfilter, aufweisen. Diese kann wie gezeigt der Signalgeneratoranordnung 130 nachgeschaltet sein, um das Ansteuerungssignal zur elektrischen Ansteuerung des Sensorelements 20 über den Kontrollpfad KP gefiltert an die Sensorkontrollanordnung 170 auszugeben, insbesondere durch eine Tiefpassfilterung. Auf diese Weise lässt sich das Ansteuerungssignal mit einer bestimmten Arbeitsfrequenz formen, sodass vorzugsweise eine Emission des Sensorelements 20 durch die Filteranordnung 140 angepasst ist. Damit können vorteilhafterweise EMV (Elektromagnetische Verträglichkeit) Vorgaben bei dem Betrieb der Anordnung 10 umgesetzt werden. In anderen Worten kann die Kontrollanordnung 100 eine Filteranordnung 140, insbesondere ein aktives Filter 140, aufweisen, welches die Signalgeneratoranordnung 130 mit dem Kontrollpfad KP verbindet, um ein durch die Signalgeneratoranordnung 130 erzeugtes elektrisches Signal am Kontrollpfad KP gefiltert, insbesondere tiefpassgefiltert, und/oder geformt bereitzustellen, und dadurch als ein gefiltertes elektrisches Signal, vorzugsweise Sinussignal, bereitzustellen. Die aktive Filterung wird dabei vorzugsweise durch einen Operationsverstärker 140.1 und durch Filterelemente 140.2 wie wenigstens einen Kondensator und/oder wenigstens einen Widerstand und/oder wenigstens eine Spule ermöglicht.

Das elektrische Signal (Ansteuerungssignal) am Kontrollpfad KP und insbesondere am Anschluss 170.C kann nun ggf. über weitere Komponenten wie der Sensorkontrollanordnung 170 und über ein Schaltelement 180 (ggf. über einen Anschluss 180.A) an das Sensorelement 20 ausgegeben werden. Um die hierdurch bewirkte Ladungsübertragung an das Sensorelement 20 zu unterbrechen und z. B. wenigstens ein weiteres Sensorelement 20' aufzuladen, kann das Schaltelement 180 getaktet geöffnet und anschließend wieder geschlossen werden. Die Sensorkontrollanordnung 170 kann einen Verstärker und/oder einen Spannungsfolger und/oder einen Spannungsvervielfacher aufweisen, um ein elektrisches Potential am Anschluss 170.C in gleicher Weise am Sensorelement 20 zu erzeugen, bevorzugt sodass das elektrische Potential am Sensorelement 20 dem elektrischen Potential am Anschluss 170.C folgt. Hierzu weist die Sensorkontrollanordnung 170 z. B. einen Operationsverstärker 170.1 und/oder wenigstens ein Filterelement 170.2, wie einen Kondensator 170.2, auf. Ein weiteres Schaltelement 180 kann z. B. im Pfad zwischen dem Anschluss 170.A und dem weiteren Sensorelement 20' integriert sein, und z. B. im Wechsel mit dem Schaltelement 180 geschaltet werden.

Die Sensorkontrollanordnung 170 kann den Operationsverstärker 170.1 als ein Übertragungselement 170.1 aufweisen, welches mit der Signalgeneratoranordnung 130 elektrisch verschaltet ist, um anhand des Ansteuerungssignals (am Anschluss 170.C) wiederholte Ladungsübertragungen bei dem Sensorelement 20 zu initiieren. Dies ermöglicht eine zumindest teilweise Auf- und wieder Entladung des Sensorelements 20, und damit eine Auswertung der im Sensorelement 20 gespeicherten Ladung. Hierzu kann bspw. eine Menge (Anzahl) der übertragenen Ladungen und/oder eine Stromstärke bei den Ladungsübertragungen ausgewertet werden. Die Ladungsmenge und/oder Stromstärke ist dann spezifisch für Sensorkapazität CS, insbesondere für die Veränderung der Sensorkapazität CS. Für diese Auswertung des Sensorelements 20 kann die Sensorkontrollanordnung 170 ferner das wenigstens eine Filterelement 170.2 als ein Verstärkungsmittel 170.2 aufweisen, welches mit der Auswerteanordnung 200 (und auch mit dem Sensorelement 20) elektrisch verschaltet ist, und so anhand der Ladungsübertragungen das Sensorsignal bereitstellt. Das Sensorsignal ist spezifisch für die (z. B. proportional zur) Sensorkapazität CS. Konkret ist das Sensorsignal z. B. spezifisch für die Stromstärke des elektrischen Stroms und/oder einer Spannung, welche(r) am Anschluss 170.A vorliegt, und damit spezifisch für die Ladungsübertragungen bzw. die Sensorkapazität CS.

Um anhand des Sensorsignals Rückschlusse auf die Sensorkapazität CS zu ermöglichen, kann das Verstärkungsmittel 170.2, wie in Figur 3 dargestellt ist, mit dem Sensorelement 20 elektrisch verschaltet sein, um Ladungsübertragungen (also einen elektrischen Stromfluss) zwischen dem Sensorelement 20 und dem Verstärkungsmittel 170.2 bereitzustellen. Ferner kann das Verstärkungsmittel 170.2 einen Ausgang des Übertragungselements 170.1 mit einem (insbesondere invertierenden) ersten Eingang des Übertragungselements 170.1 elektrisch verbinden, sodass das Verstärkungsmittel 170.2 eine Gegenkopplung für das Übertragungselement 170.1 ausbildet. Die Gegenkopplung ermöglicht es, dass die Ladungsübertragungen durch das Ansteuerungssignal gesteuert werden, wenn das Ansteuerungssignal am anderen (insbesondere nicht invertierenden) zweiten Eingang des Übertragungselements 170.1 anliegt. Wenn der erste Eingang direkt mit dem Anschluss 170.A elektrisch verbunden ist, wie es auch in Figur 3 gezeigt ist, wird auf diese Weise durch die Sensorkontrollanordnung 170 ein Spannungsfolger für das Sensorelement 20 bereitgestellt, sodass die Spannung am (insbesondere niederohmigen) Anschluss 170.A dem Ansteuerungssignal am (insbesondere hochohmigen) Anschluss 170.C folgt. Dies entspricht der Steuerung der Ladungsübertragungen am Anschluss 170.A durch das Ansteuerungssignal, und damit einer (insbesondere niederohmigen) Sensorspeisung. Das Sensorsignal kann hingegen mittels der Anordnung (Verstärkeranordnung) aus dem Übertragungselement 170.1 und dem Verstärkungsmittel 170.2 bereitgestellt werden, bei welcher es sich um einen elektronischen Verstärker handeln kann.

Vorzugsweise ist das Übertragungselement 170.1 als Operationsverstärker 170.1 ausgebildet. Das Verstärkungsmittel 170.2 weist hingegen wenigstens ein oder zwei Filterelement(e) 170.2 auf, bei welchen jedoch ein Kondensator C (z. B. gegenüber einem Widerstand R) dominieren kann. Damit kann die Konfiguration der Anordnung aus dem Übertragungselement 170.1 und dem Verstärkungsmittel 170.2 auch als eine Integrier-Schaltung angesehen werden. Der Kondensator C ermöglicht es, durch diese Anordnung einen elektronischen Verstärker bereitzustellen, bei welchem anhand der Ladungsübertragungen das Sensorsignal in der Form einer zur Sensorkapazität CS proportionalen elektrischen Spannung erzeugt wird. In anderen Worten weist die Sensorkontrollanordnung 170 die Anordnung aus dem Übertragungselement 170.1 und dem Verstärkungsmittel 170.2 aufweist, um das Sensorsignal mit einer Verstärkung bereitzustellen. Dies bedeutet, dass das Sensorsignal abhängig ist von, und vorzugsweise proportional ist zu, einer Spannung U1 an einem ersten Anschluss 170.A der Sensorkontrollanordnung 170 (bzw. an dem ersten Eingang des Operationsverstärkers 170.1), verstärkt durch einen Verstärkungsfaktor. Der Verstärkungsfaktor kann abhängig sein von, und vorzugsweise proportional sein zu, einem Verhältnis der Sensorkapazität CS zur Kapazität Cmess des Kondensators C. Die Spannung U1 (das Ausgangssignal) am Anschluss 170.A kann wiederrum durch die Nutzung des Spannungsfolgers bzw. einer direkten Gegenkopplung dem Ansteuerungssignal in der Form einer Spannung U0 am Anschluss 170.C im Wesentlichen entsprechen. Somit ergibt sich folgender Zusammenhang für das Sensorsignal, welches als Spannung U2 am Anschluss 170.B der Sensorkontrollanordnung 170 vorliegen kann: $U 2 = U 0 * \left(1+CS/Cmess\right)$

Es ist erkennbar, dass das Sensorsignal U2 in Abhängigkeit von der veränderlichen Sensorkapazität CS und der Kapazität Cmess verstärkt ist, d. h. als verstärkte Spannung U0 erzeugt wird. Folglich kann das Sensorsignal zur Ermittlung der Sensorkapazität CS dienen. Um die dargestellte Linearität zwischen dem Sensorsignal und der Sensorkapazität CS zu ermöglichen, wird der Widerstand R des Verstärkungsmittels 170.2 möglichst groß gegenüber (1/(2*π*f0*CSmax)) gewählt, wobei hier f0 die Arbeitsfrequenz, also insbesondere die (mittlere) Frequenz des Ansteuerungssignals, und CSmax der maximal vorgesehene Wert der Sensorkapazität CS ist. Dabei kann die Kapazität Cmess ggf. identisch zur maximalen veränderlichen Sensorkapazität gewählt werden. Die Einstellung von Cmess ermöglicht folglich auch die Einstellung eines Dynamikumfangs bei der Auswertung des Sensorelements 20. Darüber hinaus wird durch die Anordnung aus dem Übertragungselement 170.1 und dem Verstärkungsmittel 170.2 in Zusammenwirkung mit der Sensorkapazität CS ein Filterverhalten (insbesondere Bandpass-Verhalten) bereitgestellt, welches an die Arbeitsfrequenz angepasst sein kann.

Die maximale veränderliche Sensorkapazität ist bspw. die Kapazität (der Kapazitätswert), welche die Sensorkapazität CS bei der Aktivierungshandlung maximal annehmen kann.

Ebenfalls ist es denkbar, dass das Verstärkungsmittel 170.2 als wenigstens ein Filterelement 140.2 einen Kondensator C und/oder einen Widerstand R aufweist, wobei der Kondensator C (bzw. die Kapazität Cmess des Kondensators C) und/oder der Widerstand R an eine maximale veränderliche Sensorkapazität CS angepasst ist. Bevorzugt kann dabei die Kapazität Cmess des Kondensators C der maximalen veränderlichen Sensorkapazität CS entsprechen. Der Kondensator C kann zur Gegenkopplung bei dem Übertragungselement 170.1 (insbesondere Operationsverstärker 170.1) der Sensorkontrollanordnung 170 ausgebildet sein, und somit vorzugsweise einen Rückkopplungskondensator C ausbilden. Über den Kondensator C kann der Ausgang des Übertragungselements 170.1 und insbesondere der Ausgang 170.B, an welchem das Sensorsignal anliegt, auf einen Eingang des Übertragungselements 170.1 zurückgeführt werden. Zudem kann dieser Eingang mit dem Anschluss 170.A direkt verbunden sein, an welchem das Sensorelement 20 (ggf. über ein Schaltelement 180) angeschlossen ist, und somit das Ausgangssignal bzw. eine elektrische Spannung des Sensorelements 20 anliegt. Auf diese Weise kann das Ausgangssignal über eine direkte Gegenkopplung entsprechend dem Ansteuerungssignal erzeugt werden (diesem folgen). Zudem kann auf diese Weise das Ansteuerungssignal bzw. das Ausgangssignal abhängig von den (durch das Ausgangssignal initiierten) Ladungsübertragungen am Sensorelement 20 verstärkt (mit einem von der Sensorkapazität abhängigen Verstärkungsfaktor) werden, und sodann als das Sensorsignal verstärkt am Anschluss 170.B ausgegeben werden.

Für die Auswertung des für die Erfassung spezifischen Parameters und insbesondere der veränderlichen Sensorkapazität CS ist entsprechend den obigen Ausführungen die Ladungsübertragung vom Sensorelement 20 (bzw. des weiteren Sensorelements 20') an die Sensorkontrollanordnung 170 vorgesehen, um diese Ladungsübertragung anhand des Sensorsignals durch eine Auswerteanordnung 200 auszuwerten. Dabei wird zur wiederholten Ermittlung wiederholt eine Ladungsübertragung vom Sensorelement 20 an die Sensorkontrollanordnung 170 durchgeführt, um abhängig von der Menge der dabei übertragenen Ladung eine Speicheranordnung 250, vorzugsweise einen Integrator 250, der Auswerteanordnung 200 aufzuladen. In anderen Worten wird abhängig von, und vorzugsweise proportional zu, dem Sensorsignal die Speicheranordnung 250 aufgeladen. Auf diese Weise kann die durch die Speicheranordnung 250 gespeicherte elektrische Ladung für die Veränderung der Kapazität CS spezifisch sein. Hierzu kann die Speicheranordnung 250 z. B. mittels eines Speicherkondensators eine Speicherkapazität CL bereitstellen.

Die Kontrollvorrichtung 300 kann über einen Anschluss 250.A mit der Speicheranordnung 250 der Auswerteanordnung 200 verschaltet sein, um die durch die Speicheranordnung 250 gespeicherte elektrische Ladung zur Ermittlung des für die Erfassung spezifischen Parameters auszuwerten. Es wird somit hierbei ein Auswertesignal erfasst und ausgewertet, welches spezifisch ist für den Parameter und/oder die gespeicherte elektrische Ladung. Das Auswertesignal kann z. B. eine Spannung über einen Kondensator der Speicheranordnung 250 sein.

Ebenfalls ist in Figur 3 erkennbar, dass die Schildkontrollanordnung 150 und die Sensorkontrollanordnung 170 mit der gleichen Signalgeneratoranordnung 130 und gleichen Filteranordnung 140 über den Kontrollpfad KP elektrisch verschaltet sind. Hierdurch wird ein durch die Signalgeneratoranordnung 130 erzeugtes und/oder durch die Filteranordnung 140 gefiltertes elektrisches Signal (das Ansteuerungssignal) am Kontrollpfad KP sowohl zur Ansteuerung des Sensorelements 20 als auch des Schildelements 160 genutzt, vorzugsweise mit einer im Wesentlichen identischen Signalform des Signals, bevorzugt einer zumindest annähernden Sinusform, sodass eine elektrische Potentialdifferenz zwischen dem Sensorelement 20 und dem Schildelement 160 im Betrieb der Anordnung 10 während der Ansteuerung und/oder Erfassung stets minimiert wird. Das Schildelement 160 kann dabei als aktives Schildelement 160 (sogenanntes "Active Shield") zur aktiven Abschirmung des Sensorelements 20 ausgeführt sein, sodass mittels der Schildkontrollanordnung 150 ein elektrisches Potential am Schildelement 160 dem elektrischen Potential an dem Sensorelement 20 aktiv nachgeführt wird. Dies ermöglicht es, eine Abschirmung des Sensorelements 20 von dem Fahrzeug 1 zu verbessern und somit eine Last zu reduzieren, die zwischen dem Sensorelement 20 und dem Fahrzeug 1 vorliegt. Diese Last führt üblicherweise zu einem relativ großen Anteil bei dem Auswertesignal, welches durch die Kontrollvorrichtung 300 ausgewertet wird. Der aufgrund der veränderbaren Sensorkapazität CS variable Anteil des Auswertesignals ist somit reduziert und daher nur erschwert auswertbar. Zur Verbesserung der Auswertung wird optional eine Kompensationsanordnung 230 eingesetzt. Diese zweigt z. B. je nach Amplitude des Auswertesignals einen Teil des elektrischen Stroms von der Speicheranordnung 250 ab. Die Nutzung eines Schildelements 160, welches zur Abschirmung das gleiche Potential aufweist wie das Sensorelement 20, kann die beschriebenen Schwierigkeiten bei der Auswertung weiter reduzieren.

Es kann wiederholt eine Aufladung und Entladung des Sensorelements 20 über den ersten Anschluss 170.A der Sensorkontrollanordnung 170 mittels der Ladungsübertragungen durchgeführt werden. Diese wiederholten Auf- und Entladungen können durch das Ansteuerungssignal (aufgrund einer sich periodisch verändernden Spannungsamplitude des Ansteuerungssignals) gesteuert werden. In Abhängigkeit von den Ladungsübertragungen kann ein elektrisches Sensorsignal über den zweiten Anschluss 170.B der Sensorkontrollanordnung 170 ausgegeben werden. Es ist möglich, dass eine elektrische Filterung des Sensorsignals durchgeführt wird. Entsprechend kann es sich um eine Filterung für den Auswertezweig bei der Übertragung des Sensorsignals an die Speicheranordnung 250 handeln, welche somit keinen Einfluss auf das elektrische Signal der elektrischen Ansteuerung (am Kontrollpfad KP) und damit auf die Aufladung des Sensorelements 20 hat. Hierzu kann eine Auswertefilteranordnung 210 genutzt werden, um eine Filterung (wie z. B. eine Bandpassfilterung) des elektrischen Sensorsignals durchzuführen. Dies ermöglicht es, dass die Auswertefilteranordnung 210 störende Immissionen aus der Umgebung des Sensorelements 20 herausfiltern kann. Damit kann die Auswertefilteranordnung 210 eine EMV-Filterung von Immissionen bereitstellen. Hierzu weist die Auswertefilteranordnung 210 z. B. einen komplexen Widerstand und zusätzlich Filterelemente auf. Es ist dabei denkbar, dass die beschriebene Form (z. B. Sinusform) des elektrischen Signals der elektrischen Ansteuerung am Kontrollpfad KP (d. h. des Ansteuerungssignals) die elektrische Spannung des Signals betrifft. Die Spannung des Sensorsignals am Anschluss 170.B kann die gleiche Form aufweisen, jedoch ggf. eine (proportional zur Sensorkapazität CS) verstärkte Amplitude. Allerdings kommt es bei der Auswertung ggf. auf die Ladungsübertragung und damit den elektrischen Strom bei der Übertragung des Sensorsignals an die Speicheranordnung 250 an. Daher kann die Auswertefilteranordnung 210 einen Transkonduktanzwandler aufweisen, um eine Transkonduktanzwandlung des Sensorsignals am Anschluss 170.B durchzuführen. Unter einer solchen Transkonduktanzwandlung wird verstanden, dass eine Spannung in einen dazu proportionalen Strom umgewandelt wird. In anderen Worten kann die Auswertefilteranordnung 210 dazu ausgebildet und/oder derart in der Auswerteanordnung 200 verschaltet sein, dass aus der Spannung des elektrischen Signals (Sensorsignals) am zweiten Anschluss 170.B mit der beschriebenen Form (z. B. Sinusform) ein elektrischer Strom mit dieser Form am Ausgang 210.A der Auswertefilteranordnung 210 gebildet wird. Der Transkonduktanzwandler ist z. B. als ein Transkonduktanzverstärker (unter Verwendung eines Operationsverstärkers) ausgebildet, stellt bevorzugt jedoch die Transkonduktanzwandlung ohne Operationsverstärker aufgrund der Verschaltung mit der Speicheranordnung 250 bereit. Dies wird z. B. durch die Schaltungskonfiguration der Auswertefilteranordnung 210 in Reihe zur Speicheranordnung 250 möglich. Ferner können die nachgeschalteten Komponenten 220, 250 niederohmig sein, und/oder die Speicheranordnung 250 z. B. am Eingang 250.B den invertierenden Eingang (-) eines Verstärkungselements, und insbesondere Operationsverstärkers aufweisen. Das Verstärkungselement der Speicheranordnung 250 kann dazu ausgeführt sein, dass bei einer auftretenden Spannung am Eingang 250.B unverzüglich Gegenmaßnahmen eingeleitet werden. Hierzu kann ein Operationsverstärker die Differenzspannung seiner Eingänge mittels einer Rückkopplung auf Null regeln. Diese Vorkehrungen und/oder die Anordnung der Auswerteanordnung 200 seriell zur Speicheranordnung 250 bewirken, dass nahezu keine Spannung am Eingang 250.B bzw. Ausgang 210.A abfällt. In anderen Worten liegt an diesem Punkt (am Eingang 250.B bzw. am Ausgang 210.A, wenn diese miteinander z. B. über einen Schalter der Gleichrichteranordnung 220 verbunden sind) nahezu ein Massepotential vor, sodass dieser Punkt als ein virtueller Nullpunkt angesehen werden kann.

Der in Figur 3 gezeigte Block 220 kann ein oder mehrere Gleichrichter betreffen, und damit eine Gleichrichteranordnung 220. Die Gleichrichteranordnung 220 kann ggf. ohne Dioden oder dergleichen auskommen, sodass im Wesentlichen kein (bzw. nahezu kein) Spannungsabfall an der Gleichrichteranordnung 220 erfolgt. Dies kann bspw. dadurch umgesetzt werden, dass die Gleichrichtung mittels wenigstens eines elektronischen Schalters durchgeführt wird, welcher getaktet geschaltet wird. Auf diese Weise kann bei der Herstellung der elektrischen Verbindung des Ausgangs 210.A mit dem Eingang 250.B durch die Gleichrichteranordnung 220 und insbesondere durch den wenigstens einen Schalter ein virtueller Nullpunkt für den Eingang 250.B bzw. Ausgang 210.A bereitgestellt werden (wenn der Schalter geschlossen wird). Wenn hingegen der wenigstens eine Schalter geöffnet wird, kann der Ausgang 210.A der Auswertefilteranordnung 210 auf ein Massepotential 21 gelegt werden. Bspw. verbindet hierzu der Schalter als Wechselschalter den Ausgang 210.A mit dem Massepotential 21. Auf diese Weise kann stets zumindest annähernd ein Massepotential am Ausgang 210.A anliegen, unabhängig von der Schalterstellung des wenigstens einen Schalters bei der Gleichrichteranordnung 220. Damit wird eine Belastung der Auswertefilteranordnung 210 deutlich verringert.

Bei der beschriebenen Gleichrichtung kann es sich um eine "kohärente" Gleichrichtung durch den wenigstens einen Gleichrichter handeln. Darunter wird verstanden, dass der wenigstens eine Gleichrichter jeweils mit einem vorgegebenen Takt das elektrische Signal (Sensorsignal) von der Auswertefilteranordnung 210 an die Speicheranordnung 250 weiterleitet, vorzugsweise phasen-synchronisiert mit der elektrischen Ansteuerung. Dies bewirkt, dass das Sensorsignal kohärent zum Ansteuerungssignal gleichgerichtet wird. Hierzu kann jeder der Gleichrichter wenigstens einen elektronischen Schalter aufweisen. Der Takt kann dabei jeweils derart vorgegeben sein, dass nur positive (oder alternativ negative) Halbwellen einer jeweils vorgegebenen Grundschwingung bzw. Harmonischen des elektrischen Signals (z. B. mit der ersten Harmonischen als die Grundschwingung der Frequenz, welche durch die Auswertefilteranordnung 210 als Mittenfrequenz durchgelassen wird, und ggf. weiteren Harmonischen) weitergeleitet werden. Daher kann der jeweilige Takt mit der Signalgeneratoranordnung 130 synchronisiert sein, um an die Form des elektrischen Signals (Ansteuerungssignals) der elektrischen Ansteuerung angepasst zu sein. Unter Berücksichtigung der Filterung durch die Auswertefilteranordnung 210 wird bei dieser Synchronisation die Phasenverschiebung zwischen Spannung (entsprechend dem elektrischen Signal der elektrischen Ansteuerung am Kontrollpfad KP) und Strom (entsprechend dem Signal am Ausgang 210.A der Auswertefilteranordnung 210) in Betracht gezogen. Ferner kann die Gleichrichtung ggf. auch mit Dioden "inkohärent" erfolgen.

Es ist außerdem möglich, dass die Gleichrichtung in der Form einer Einweggleichrichtung erfolgt, oder dass alternativ sowohl die positive als auch die negative Halbwelle des Sensorsignals zur Ladungsübertragung an die Speicheranordnung 250 genutzt werden.

Darüber hinaus kann es vorgesehen sein, dass eine Frequenz des Sensorsignals (als periodisches Signal) abhängig ist von einer Arbeitsfrequenz, d. h. der Frequenz des Ansteuerungssignals am Anschluss 170.C (bzw. am Ausgang der Filteranordnung 140). Somit kann für die gesamte Anordnung 10 eine einzige Arbeitsfrequenz sowohl für die Ansteuerung als auch für die Auswertung des Sensorelements 20 genutzt werden, um die Ansteuerung und Auswertung des Sensorelements 20 mit einem vorgegebenen Arbeitsfrequenzbereich durchzuführen. Hierzu wird eine Filterung bei der elektrischen Ansteuerung (durch die Filteranordnung 140) und bei der Auswertung (durch die Auswertefilteranordnung 210) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV-Bedingungen (bei Emissionen) und störenden Einwirkungen (bei Immissionen).

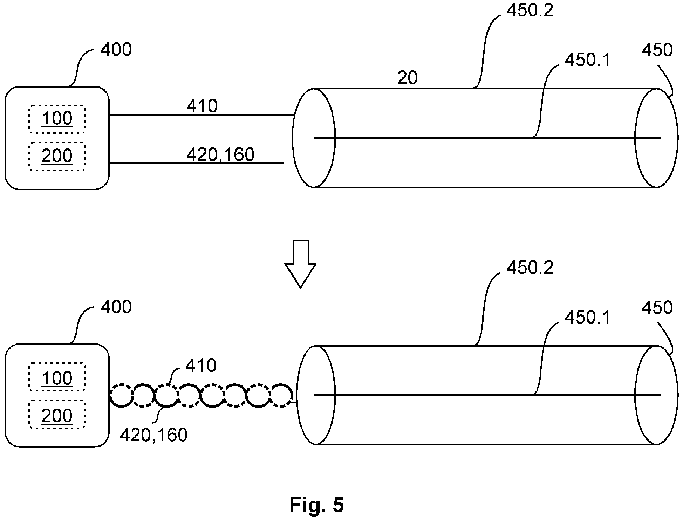

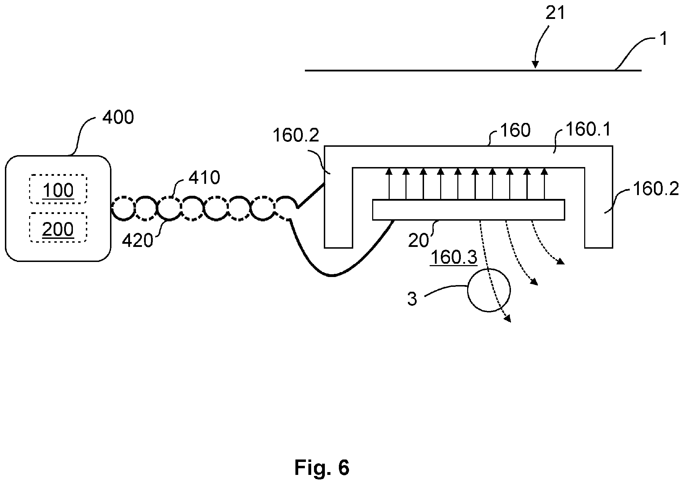

Figur 5 zeigt eine mögliche Ausgestaltung der erfindungsgemäßen Anordnung 10, wenn diese mit einem langgestreckten Sensorelement 20 genutzt wird. Eine solche Ausbildung findet bspw. Anwendung, wenn das Sensorelement 20 in einem Stoßfänger 1.1 an einer Front- oder Heckseite des Fahrzeuges 1 eingesetzt werden soll. Hierdurch ist es möglich, eine Bewegung des Aktivierungsmittels 3 unterhalb des Stoßfängers 1.1 als Aktivierungshandlung zu erfassen, wie es auch in Figur 6 verdeutlicht wird. Anders als bei einer Ausbildung des Sensorelements 20 als Leiterbahn einer Leiterplatte, wie es bei der Anordnung im Türgriff 1.5 zur Bereitstellung eines räumlich eher begrenzten Detektionsbereichs sinnvoll sein kann, wird bei einem größeren Detektionsbereich ein separates Sensorelement 20 mit der Leiterplatte verbunden. Hierzu kann z. B. ein Sensorelementanschluss 180.A der Leiterplatte genutzt werden, welcher eine elektrische Verbindung mit dem Schaltelement 180 bereitstellt. Dieses kann wiederum die elektrische Verbindung über die Sensorkontrollanordnung 170 und den Kontrollpfad KP sowie der Filteranordnung 140 zur Signalgeneratoranordnung 130 (zur Aufladung) bzw. über die Auswertefilteranordnung 210 und die Gleichrichteranordnung 220 zur Speicheranordnung 250 (zur Auswertung) bereitstellen. Die genannten Komponenten 170, 140, 130, 210, 220, 250 können ebenfalls an der Leiterplatte angeordnet sein.

Die Leiterplatte mit den Komponenten, in anderen Worten die Kontrollanordnung 100 und/oder die Auswerteanordnung 200, kann als ein gemeinsames Bauteil aufgefasst werden, welches nachfolgend als Sensorschaltanordnung 400 bezeichnet wird. Es ist optional möglich, dass diese Sensorschaltanordnung 400 als einzeln handhabbares und am Fahrzeug montierbares Teil ausgeführt ist. Die Sensorschaltanordnung 400 kann zur Montage der erfindungsgemäßen Anordnung 10 über wenigstens eine Sensorzuleitung 410 mit dem Sensorelement 20 und ggf. mit wenigstens einem weiteren Sensorelement 20' elektrisch verbunden sein. Das wenigstens eine weitere Sensorelement 20' kann dabei ggf. über wenigstens eine weitere Sensorzuleitung 410 mit der Sensorschaltanordnung 400 verbunden sein. Optional ist es zudem möglich, dass die Sensorschaltanordnung 400 über eine Schildleitung 420, insbesondere Schildzuleitung 420, mit wenigstens einem Schildelement 160 oder weiteren Schildelement elektrisch verbunden ist, oder dass die Schildleitung 420 das Schildelement 160 (d. h. ggf. auch ein weiteres Schildelement) bildet.

Als eine beispielhafte Ausgestaltung für die erfindungsgemäße Anordnung 10 ist ein Koaxialkabel 450 in Figur 5 schematisch gezeigt, deren Außenleiter 450.2 als Sensorelement 20 genutzt wird. In anderen Worten bildet der Schirm 450.2 des Koaxialkabels 450 das Sensorelement 20. Hierzu kann über den Anschluss 180.A der Sensorschaltanordnung 400 die Sensorzuleitung 410 mit dem Außenleiter 450.2 elektrisch verbunden werden. Der Anschluss 180.A überträgt dabei das elektrische Signal der elektrischen Ansteuerung, welches von der Signalgeneratoranordnung 130 und/oder der Filteranordnung 140 vorgegeben (also erzeugt und ggf. gefiltert) und ferner durch eine Sensorkontrollanordnung 170 am Anschluss 180.A ausgegeben werden kann. In gleicher Weise kann über einen Schildelementanschluss 150.A der Sensorschaltanordnung 400 eine Schildzuleitung 420 mit einem Schildelement 160 verbunden sein (siehe Figur 6) oder die mit dem Schildelementanschluss 150.A verbundene Schildleitung 420 selbst das Schildelement 160 (oder ggf. auch ein weiteres Schildelement) bilden. Insbesondere im letzteren und in Figur 5 gezeigten Fall kann es sinnvoll sein, wenn das Schildelement 160 als passives Schildelement 160 betrieben wird. Der Innenleiter 450.1 (d. h. die Seele) des Koaxialkabels 450 kann ggf. unverbunden bleiben.

Bei einem Betrieb als passives Schildelement 160 wird das Schildelement 160 im Betrieb (stets bzw. während des Auf- und/oder Entladens des Sensorelements 20) mit einem vorgegebenen konstanten elektrischen Potential über den Schildelementanschluss 150.A verbunden. Das elektrische Potential des Schildelements 160 kann dabei einem Massepotential 21 entsprechen oder ein davon abweichendes Potential sein. Im Gegensatz hierzu kann beim Betrieb als aktives Schildelement 160 das elektrische Potential des Schildelements 160 in Abhängigkeit vom elektrischen Potential des Sensorelements 20 nachgeführt und variiert werden.

Es ist über einen Pfeil in Figur 5 verdeutlicht, dass zur Montage der erfindungsgemäßen Anordnung 10 am Fahrzeug 1 eine Verdrillung der Zuleitungen 410, 420 durchgeführt werden kann. Zunächst kann dabei das Schildelement 160 in der Form einer Schildleitung 420 als langestreckte Schildelektrode 160 parallel zur Sensorzuleitung 410 verlaufen. Die Verdrillung kann z. B. durch ein Gegeneinanderverwinden und ein schraubenförmiges Umeinanderwickeln der Sensorzuleitung 410 mit der Schildleitung 420 erfolgen. Die verdrillten Zuleitungen 410, 420 sind mit einer gestrichelten und durchgehenden Linie hervorgehoben. Auf diese Weise kann die Empfindlichkeit gegenüber äußere elektromagnetische Störeinflüsse auf die Zuleitungen 410, 420 reduziert werden. Anschließend kann zur Montage die Sensorzuleitung 410 mit dem Außenleiter 450.2 elektrisch verbunden werden, sodass der Außenleiter 450.2 das Sensorelement 20 bildet. Die Schildleitung 420 sowie die Seele 450.1 des Koaxialkabels 450 bleiben ggf. unverbunden. Alternativ wird die Schildleitung 420 mit der Seele 450.1 elektrisch verbunden. Bei dieser Konfiguration ist es vorteilhaft, wenn das Schildelement 160 als passives Schildelement 160 verwendet wird.

Alternativ ist auch ein Betrieb des Schildelements 160 bzw. der Schildleitung 420 als aktives Schildelement 160 sinnvoll. Hierzu wird ggf. eine andere Verschaltung am Koaxialkabel 450 gewählt. Dabei kann die Sensorzuleitung 410 mit der Seele 450.1 (also dem Innenleiter 450.1) des Koaxialkabels 450 elektrisch verbunden werden, sodass die Seele 450.1 als Sensorzuleitung dient. Die Schildleitung 420, in diesem Fall ggf. als Schildzuleitung 420, kann mit dem Außenleiter 450.2 (d. h. mit der Abschirmung) des Koaxialkabels 450 elektrisch verbunden werden, sodass der Außenleiter 450.2 das aktive Schildelement 160 bildet. Das Koaxialkabel 450 mit der Seele 450.1 kann dabei als Zuleitung zum Sensorelement 20 dienen, welches dann allerdings separat vom Koaxialkabel 450 ausgeführt ist. Der Außenleiter 450.2 bewirkt als aktives Schildelement 160 eine verbesserte Abschirmung der Sensorzuleitung 410. Die Zuleitung 410, 420 zum Koaxialkabel 450 kann wie zuvor beschrieben verdrillt sein, oder es kann sich um parallel geführte Leitungen handeln.

Ein separates Sensorelement 20, welches z. B. über die zuvor beschriebenen verdrillten Zuleitungen 410, 420 und/oder über das Koaxialkabel 450 mit dem Außenleiter 450.2 als aktives Schildelement 160 und/oder über eine davon abweichende Variante, mit der Sensorschaltanordnung 400 verbunden ist, ist beispielhaft in Figur 6 gezeigt. Das Sensorelement 20 kann z. B. als elektrisch leitfähige Fläche (sogenannte Flachelektrode 20) und/oder als eine elektrisch leitfähige Leitung oder dergleichen ausgebildet sein. Das Sensorelement 20 ist in einer montierten Anordnung (z. B. im Heckbereich) in der Nähe zu weiteren Teilen des Fahrzeuges 1 gezeigt. Schematisch angedeutet ist dabei ein Teil des Fahrzeuges 1, welcher als Massepotential 21 angesehen werden kann. Das Fahrzeug 1 kann eine Last auf das Sensorelement 20 verursachen, welcher durch eine Abschirmung entgegengewirkt werden kann. Es wird dabei durch Pfeile das elektrische Feld verdeutlicht, welches zwischen einem Schildelement 160 und dem Sensorelement 20 auftreten kann (und durch den Betrieb des Schildelements 160 als ein aktives Schildelements 160 möglichst reduziert bzw. eliminiert werden kann), und welches zur Erfassung der Aktivierungshandlung bzw. des Aktivierungsmittels 3 dient.

Besonders vorteilhaft ist dabei die gezeigte Form des (aktiven) Schildelements 160. Die Form ist bspw. eine U-Form, wobei die beiden gegenüberstehenden Seitenteile 160.2 des Schildelements 160 einen seitlichen Bereich und ein Mittenteil 160.1 des Schildelements 160 den Mittenbereich bzw. die Fahrzeugseite abschirmt. Auf diese Weise kann der Detektionsbereich sehr genau durch den offenen Bereich 160.3 des Schildelements 160 zwischen den Seitenteilen 160.2 definiert werden. Das Schildelement 160 kann z. B. dadurch als aktives Schildelement 160 betrieben werden, dass es mit der Schild(zu)leitung 420 bzw. mit einem Außenleiter 450.2 des Koaxialkabels 450 (wenn dieses als Zuleitung verwendet wird) elektrisch verbunden wird. Das Sensorelement 20 kann ferner mit der Sensorzuleitung 410 und/oder mit der Seele 450.1 des Koaxialkabels 450 (wenn dieses als Zuleitung verwendet wird) elektrisch verbunden werden. Alternativ kann die Form auch anders als eine U-Form ausgebildet sein, insbesondere wenn das Schildelement 160 breiter ist als das Sensorelement 20.

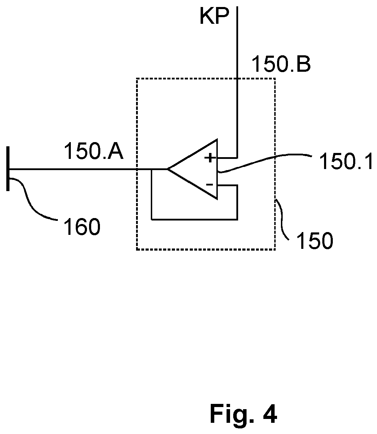

In Figur 4 ist eine Schildkontrollanordnung 150 in einer beispielhaften Ausführung mit weiteren Einzelheiten gezeigt. Ein Operationsverstärker 150.1 mit einem invertierenden (-) und nicht invertierenden (+) Eingang kann dabei genutzt werden, um die Schildkontrollanordnung 150 als einen Spannungsfolger auszubilden. Dies ermöglicht eine einfache und kostengünstige Bereitstellung des elektrischen Signals der elektrischen Ansteuerung für das Schildelement 160 in gleicher Weise wie für das Sensorelement 20.

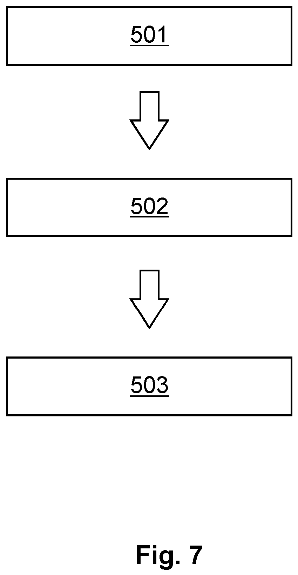

Durch Figur 7 ist ein Verfahren für das Fahrzeug 1 zur Detektion einer Aktivierungshandlung für die Aktivierung einer Funktion am Fahrzeug 1 schematisch visualisiert. Dabei erfolgt gemäß einem ersten Verfahrensschritt 501 ein Ansteuern eines Sensorelements 20 durch eine elektrische Ansteuerung über einen Kontrollpfad KP, um eine Erfassung einer Veränderung, insbesondere einer Annäherung durch ein Aktivierungsmittel 3, in einer Umgebung des Sensorelements 20 bereitzustellen. Gemäß einem zweiten Verfahrensschritt 502 erfolgt ein Ermitteln wenigstens eines für die Erfassung spezifischen Parameters des Sensorelements 20, um die Detektion der Aktivierungshandlung durchzuführen. Gemäß einem dritten Verfahrensschritt 503 erfolgt ein Bereitstellen der (gleichen) elektrischen Ansteuerung über den Kontrollpfad KP für ein Schildelement 160, welches zur Abschirmung des Sensorelements 20 benachbart zum Sensorelement 20 angeordnet ist. Der dritte Verfahrensschritt 503 kann dabei ggf. parallel und/oder synchron zu den Verfahrensschritten 501 und/oder 502 durchgeführt werden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 1.1: Stoßfänger
- 1.2: Heckbereich
- 1.3: Heckklappe
- 1.4: Seitenbereich
- 1.5: Türgriff
- 1.6: Tür
- 1.7: Frontbereich
- 2: Benutzer
- 3: Aktivierungsmittel
- 5: Identifikationsgeber
- 8: Steuergerät

- 10: Anordnung

- 20: Sensorelement, Sensorelektrode
- 21: Massepotential

- 100: Kontrollanordnung

- 130: Signalgeneratoranordnung, Signalgenerator
- 130.1: Digital-Analog-Konverter

- 140: Filteranordnung, Aktives Filter, Sinusfilter
- 140.1: Operationsverstärker
- 140.2: Filterelement
- 150: Schildkontrollanordnung
- 150.A: Schildelementanschluss
- 150.B: Schildkontrolleingang
- 150.1: Operationsverstärker
- 160: Schildelement
- 160.1: Mittenteil
- 160.2: Seitenteil, Schenkel
- 160.3: Detektionsbereich, offener Bereich
- 170: Sensorkontrollanordnung, Spannungsfolger
- 170.A: erster Anschluss von 170
- 170.B: zweiter Anschluss von 170
- 170.C: dritter Anschluss von 170
- 170.1: Operationsverstärker
- 170.2: Filterelement

- 180: Schaltelement
- 180.A: Ausgang von 180, Sensorelementanschluss

- 20': weiteres Sensorelement

- 200: Auswerteanordnung
- 210: Auswertefilteranordnung
- 210.A: erster Anschluss bzw. Ausgang von 210

- 220: Gleichrichteranordnung
- 230: Kompensationsanordnung

- 250: Speicheranordnung, Integrator
- 250.A: erster Anschluss
- 250.B: zweiter Anschluss, Eingang

- 300: Kontrollvorrichtung, Mikrocontroller

- 400: Sensorschaltanordnung
- 410: Sensorzuleitung
- 420: Schildzuleitung

- 450: Koaxialkabel
- 450.1: Innenleiter, Seele
- 450.2: Außenleiter

- 501: erster Verfahrensschritt
- 502: zweiter Verfahrensschritt
- 503: dritter Verfahrensschritt

- CL: Speicherkapazität
- CS: Sensorkapazität
- KP: Kontrollpfad

## Patentansprüche

1. Anordnung (10) für ein Fahrzeug (1) zur Detektion einer Aktivierungshandlung für die Aktivierung einer Funktion am Fahrzeug (1), insbesondere zur Detektion einer Aktivierungshandlung in einem Front-, Seiten- und/oder Heckbereich (1.7, 1.4, 1.2) des Fahrzeuges (1) für die Aktivierung einer Öffnung und/oder Entriegelung einer Klappe (1.3, 1.6) am Fahrzeug (1), aufweisend:
- wenigstens ein Sensorelement (20) zur Erfassung einer Veränderung, insbesondere einer Annäherung durch ein Aktivierungsmittel (3), in einer Umgebung des Sensorelements (20),
- eine Kontrollanordnung (100), welche zur elektrischen Ansteuerung des Sensorelements (20) über einen Kontrollpfad (KP) mit dem Sensorelement (20) elektrisch verschaltet ist, um die Erfassung bereitzustellen,
- eine Auswerteanordnung (200) zur wiederholten Ermittlung wenigstens eines für die Erfassung spezifischen Parameters des Sensorelements (20), um die Detektion der Aktivierungshandlung durchzuführen,
- wenigstens ein Schildelement (160), welches zur Abschirmung des Sensorelements (20) benachbart zum Sensorelement (20) angeordnet ist,
- eine Schildkontrollanordnung (150), welche zur Bereitstellung der elektrischen Ansteuerung des Sensorelements (20) für das Schildelement (160) elektrisch mit dem Kontrollpfad (KP) und dem Schildelement (160) verbunden ist,
wobei die Kontrollanordnung (100) eine Filteranordnung (140) aufweist, um ein elektrisches Signal zur elektrischen Ansteuerung des Sensorelements (20) über den Kontrollpfad (KP) gefiltert und/oder geformt bereitzustellen, sodass eine Emission des Sensorelements (20) durch die Filteranordnung (140) angepasst ist, wobei eine Sensorkontrollanordnung (170) über einen ersten Anschluss (170.A) mit dem Sensorelement (20) verschaltet ist, und über einen zweiten Anschluss (170.B) mit der Auswerteanordnung (200) verschaltet ist, und über einen dritten Anschluss (170.C) mit der Filteranordnung (140) verschaltet ist, und eine Übertragungsanordnung (170.1, 170.2) einen Spannungsfolger und/oder Spannungsvervielfacher aufweist, um ein elektrisches Potential an dem dritten Anschluss (170.C) in gleicher oder verstärkter Weise über den ersten Anschluss (170.A) am Sensorelement (20) zu erzeugen, und in gleicher oder verstärkter Weise über den zweiten Anschluss (170.B) an der Auswerteanordnung (200) zur Ermittlung zu erzeugen, wobei die Filteranordnung (140) eine Signalgeneratoranordnung (130) mit dem Kontrollpfad (KP) verbindet, um ein durch die Signalgeneratoranordnung (130) erzeugtes elektrisches Signal am Kontrollpfad (KP) gefiltert und/oder geformt bereitzustellen, und dadurch als ein gefiltertes elektrisches Signal bereitzustellen.

2. Anordnung (10) nach Anspruch 1,
**dadurch gekennzeichnet,**
**dass** die Schildkontrollanordnung (150) zur elektrischen Zwangsführung des Schildelements (160) einen Operationsverstärker (150.1) aufweist, welcher den Kontrollpfad (KP) mit dem Schildelement (160) verbindet, um eine Schildspannung am Schildelement (160) gleich zu einer Ansteuerungsspannung am Kontrollpfad (KP) zu erzeugen, wobei vorzugsweise die Ansteuerungsspannung für die elektrische Spannung am Sensorelement (20) spezifisch und/oder dazu proportional ist,
und/oder dass die Schildkontrollanordnung (150) einen Spannungsfolger ausbildet und/oder eine direkte Gegenkopplung eines Übertragungselements (150.1) aufweist, sodass ein elektrisches Potential an dem Schildelement (160) dem elektrischen Potential am Kontrollpfad (KP) und insbesondere am Sensorelement (20) folgt,
und/oder dass die Kontrollanordnung (100) eine Signalgeneratoranordnung (130) aufweist, welche für die elektrische Ansteuerung des Sensorelements (20) mit dem Sensorelement (20) elektrisch verschaltet ist, um ein elektrisches Signal zur Aufladung des Sensorelements (20) wiederholt zu erzeugen.

3. Anordnung (10) nach Anspruch 1 oder 2,
**dadurch gekennzeichnet,**
**dass** das Sensorelement (20) als eine Sensorelektrode (20) ausgebildet ist, um den für die Erfassung spezifischen Parameter als eine veränderliche Kapazität (CS) bereitzustellen, wobei die Veränderung der Kapazität (CS) für die Veränderung in der Umgebung spezifisch ist, wobei die Kontrollanordnung (100) dazu ausgeführt ist, zur wiederholten Ermittlung wiederholt eine Ladungsübertragung zwischen dem Sensorelement (20) und einer Sensorkontrollanordnung (170) zu initiieren, um in Abhängigkeit von der Ladungsübertragung eine Speicheranordnung (250), insbesondere einen Integrator (250), der Auswerteanordnung (200) aufzuladen, sodass die durch die Speicheranordnung (250) gespeicherte elektrische Ladung für die Veränderung der Kapazität (CS) spezifisch ist.

4. Anordnung (10) nach einem der vorhergehenden Ansprüche,
**dadurch gekennzeichnet,**
**dass** eine Sensorkontrollanordnung (170) über einen ersten Anschluss (170.A) mit dem Sensorelement (20) zur Ladungsübertragung elektrisch verschaltet ist, und eine elektronische Verstärkeranordnung (170.1, 170.2) aufweist, um an einem zweiten Anschluss (170.B) ein Sensorsignal anhand der Ladungsübertragung bereitzustellen, sodass das Sensorsignal spezifisch ist für eine veränderliche Kapazität (CS) des Sensorelements (20), wobei vorzugsweise eine Speicheranordnung (250) der Auswerteanordnung (200) mit der Sensorkontrollanordnung (170) über den zweiten Anschluss (170.B) verschaltet ist, um durch das Sensorsignal eine Ladungsakkumulation bei der Speicheranordnung (250) durchzuführen, sodass die durch die Speicheranordnung (250) gespeicherte elektrische Ladung für die Veränderung der Kapazität (CS) spezifisch ist.

5. Anordnung (10) nach einem der vorhergehenden Ansprüche,
**dadurch gekennzeichnet,**
**dass** eine Kontrollvorrichtung (300) mit einer Speicheranordnung (250) der Auswerteanordnung (200) verschaltet ist, um eine durch die Speicheranordnung (250) gespeicherte elektrische Ladung zur Ermittlung des für die Erfassung spezifischen Parameters auszuwerten, vorzugsweise durch eine Analog-Digital-Umwandlung einer Spannung bei der Speicheranordnung (250).

6. Anordnung (10) nach einem der vorhergehenden Ansprüche,
**dadurch gekennzeichnet,**
**dass** die Schildkontrollanordnung (150) unmittelbar mit dem Sensorelement (20) und/oder einem elektrischen Potential am Sensorelement (20) elektrisch verbunden ist, um ein elektrisches Potential am Schildelement (160) unmittelbar an das elektrische Potential am Sensorelement (20) anzugleichen,
und/oder dass die Schildkontrollanordnung (150) nur indirekt mit dem Sensorelement (20), bevorzugt über eine Sensorkontrollanordnung (170) und/oder über ein Schaltelement (180), elektrisch verbunden ist.

7. Anordnung (10) nach einem der vorhergehenden Ansprüche,
**dadurch gekennzeichnet,**
**dass** die Sensorkontrollanordnung (170) über den ersten Anschluss (170.A) mit dem Sensorelement (20) verschaltet ist, und über den zweiten Anschluss (170.B) mit der Auswerteanordnung (200) verschaltet ist, und über den dritten Anschluss (170.C) mit der Signalgeneratoranordnung (130) und/oder der Filteranordnung (140) verschaltet ist, und die Übertragungsanordnung (170.1, 170.2) aufweist, um das elektrisches Potential an dem dritten Anschluss (170.C) in gleicher oder verstärkter Weise über den ersten Anschluss (170.A) am Sensorelement (20) zu erzeugen, und in gleicher oder verstärkter Weise über den zweiten Anschluss (170.B) an der Auswerteanordnung (200) zur Ermittlung zu erzeugen, sodass das elektrische Potential am Sensorelement (20) und/oder das elektrische Potential am zweiten Anschluss (170.B) dem elektrischen Potential am dritten Anschluss (170.C) folgt.

8. Anordnung (10) nach einem der vorhergehenden Ansprüche,
**dadurch gekennzeichnet,**
**dass** die Schildkontrollanordnung (150) und eine Sensorkontrollanordnung (170) mit einer gleichen Signalgeneratoranordnung (130) und/oder gleichen Filteranordnung (140) elektrisch verschaltet sind, um ein durch die Signalgeneratoranordnung (130) erzeugtes und/oder durch die Filteranordnung (140) gefiltertes elektrisches Signal sowohl an das Sensorelement (20) als auch an das Schildelement (160) zu übertragen, vorzugsweise mit einer im Wesentlichen identischen Signalform des Signals, vorzugsweise einer zumindest annähernden Sinusform, sodass eine elektrische Potentialdifferenz zwischen dem Sensorelement (20) und dem Schildelement (160) im Betrieb der Anordnung (10) während der Ansteuerung und/oder Erfassung stets minimiert wird,
und/oder dass das Schildelement (160) als aktives Schildelement (160) ausgeführt ist, sodass mittels der Schildkontrollanordnung (150) ein elektrisches Potential am Schildelement (160) dem elektrischen Potential an dem Sensorelement (20) aktiv nachgeführt wird,
und/oder dass das Schildelement (160) eine U-Form aufweist, mit einem Mittenteil (160.1) zur Abschirmung im Mittenbereich und einem Seitenteil (160.2) zur seitlichen Abschirmung des Sensorelements (20).

9. Anordnung (10) nach einem der vorhergehenden Ansprüche,
**dadurch gekennzeichnet,**
**dass** die Anordnung (10) als kapazitive Sensoranordnung zumindest teilweise in einem Stoßfänger (1.1) des Fahrzeuges (1) integriert ist, um den Heckbereich (1.2) des Fahrzeuges (1) zu überwachen, und um als die Funktion am Fahrzeug (1) die Heckklappe (1.3) des Fahrzeuges (1) zu öffnen, insbesondere um eine Ausgabe eines Öffnungssignals und/oder eine Authentifizierungsprüfung zu initiieren,
und/oder dass die Anordnung (10) eine Sensorkontrollanordnung (170) aufweist, um wiederholt durch die elektrische Ansteuerung des Sensorelements (20) eine elektrische Ladung zwischen der Sensorkontrollanordnung (170) und dem Sensorelement (20) zu übertragen, und um zur Ermittlung des wenigstens einen für die Erfassung spezifischen Parameters des Sensorelements (20) eine Speicheranordnung (250) in Abhängigkeit von einer Ladungsmenge im Sensorelement (20) aufzuladen, wobei eine Kontrollvorrichtung (300), insbesondere wenigstens ein Mikrocontroller, mit der Speicheranordnung (250) elektrisch verbunden ist, um nach der Aufladung die Menge der in der Speicheranordnung (250) gespeicherten und/oder nach mehreren Aufladungen akkumulierten Ladung auszuwerten, und anhand der Auswertung die Detektion durchzuführen, vorzugsweise um ein Aktivierungssignal zur Aktivierung der Funktion am Fahrzeug (1) auszugeben, wenn die gespeicherte und/oder akkumulierte Ladung der Speicheranordnung (250) einen Grenzwert überschreitet.

10. Anordnung (10) nach einem der vorhergehenden Ansprüche,
**dadurch gekennzeichnet,**
**dass** das Sensorelement (20) über eine Sensorzuleitung (410) mit der Kontrollanordnung (100) verschaltet ist, wobei die Sensorzuleitung (410) mit einem weiteren Schildelement (420), jeweils in der Form eines elektrischen Kabels, verdrillt ist, wobei vorzugsweise das weitere Schildelement (420) als ein passives Schildelement betrieben wird, insbesondere unabhängig vom Potential des Sensorelements (20) auf ein festes elektrisches Potential gelegt ist,
und/oder dass das Sensorelement (20) über eine Sensorzuleitung (410) mit der Kontrollanordnung (100) verschaltet ist, wobei die Sensorzuleitung (410) als Innenleiter (450.1) eines Koaxialkabels (450) ausgebildet ist, wobei ein Außenleiter (450.2) des Koaxialkabels (450) als das Schildelement (160), insbesondere aktives Schildelement (160), ausgebildet ist.

11. System aufweisend:
- eine Anordnung (10) gemäß einem der vorhergehenden Ansprüche,
- eine Kontrollvorrichtung (300) zur Ausgabe eines Aktivierungssignals im Falle der Detektion der Aktivierungshandlung,
- ein Steuergerät (8), welches mit der Kontrollvorrichtung (300) verbunden ist, um bei Empfang des Aktivierungssignals die Funktion am Fahrzeug (1) auszuführen.

12. Verfahren für ein Fahrzeug (1) zur Detektion einer Aktivierungshandlung für die Aktivierung einer Funktion am Fahrzeug (1), insbesondere in einem Front-, Seitenund/oder Heckbereich (1.7, 1.4, 1.2) des Fahrzeuges (1) für die Aktivierung einer Öffnung und/oder Entriegelung einer Klappe (1.3, 1.6) am Fahrzeug (1), wobei **die nachfolgenden Schritte durchgeführt werden:**
- Ansteuern eines Sensorelements (20) durch eine elektrische Ansteuerung über einen Kontrollpfad (KP) durch eine Kontrollanordnung (100), um eine Erfassung einer Veränderung, insbesondere einer Annäherung durch ein Aktivierungsmittel (3), in einer Umgebung des Sensorelements (20) bereitzustellen,
- Ermitteln wenigstens eines für die Erfassung spezifischen Parameters des Sensorelements (20), um die Detektion der Aktivierungshandlung durchzuführen,
- Bereitstellen der elektrischen Ansteuerung über den Kontrollpfad (KP) für ein Schildelement (160), welches zur Abschirmung des Sensorelements (20) benachbart zum Sensorelement (20) angeordnet ist,
wobei die Kontrollanordnung (100) eine Filteranordnung (140) aufweist, um ein elektrisches Signal zur elektrischen Ansteuerung des Sensorelements (20) über den Kontrollpfad (KP) gefiltert und/oder geformt bereitzustellen, sodass eine Emission des Sensorelements (20) durch die Filteranordnung (140) angepasst ist,
wobei eine Sensorkontrollanordnung (170) über einen ersten Anschluss (170.A) mit dem Sensorelement (20) verschaltet ist, und über einen zweiten Anschluss (170.B) mit der Auswerteanordnung (200) verschaltet ist, und über einen dritten Anschluss (170.C) mit der Filteranordnung (140) verschaltet ist, und eine Übertragungsanordnung (170.1, 170.2) einen Spannungsfolger und/oder Spannungsvervielfacher aufweist, um ein elektrisches Potential an dem dritten Anschluss (170.C) in gleicher oder verstärkter Weise über den ersten Anschluss (170.A) am Sensorelement (20) zu erzeugen, und in gleicher oder verstärkter Weise über den zweiten Anschluss (170.B) an der Auswerteanordnung (200) zur Ermittlung zu erzeugen,
wobei die Filteranordnung (140) eine Signalgeneratoranordnung (130) mit dem Kontrollpfad (KP) verbindet, um ein durch die Signalgeneratoranordnung (130) erzeugtes elektrisches Signal am Kontrollpfad (KP) gefiltert und/oder geformt bereitzustellen, und dadurch als ein gefiltertes elektrisches Signal bereitzustellen.

13. Verfahren nach einem der vorhergehenden Ansprüche,
**dadurch gekennzeichnet,**
**dass** das Ansteuern des Sensorelements (20) den nachfolgenden Schritt aufweist:
- Anlegen eines elektrischen Potentials am Sensorelement (20) gemäß der elektrischen Ansteuerung, vorzugsweise durch ein elektrisches Signal mit einer vorgegebener insbesondere oszillierenden Signalform, vorzugsweise einer zumindest annähernden Sinusform, welches durch eine Filteranordnung (140) und/oder eine Signalgeneratoranordnung (130) ausgegeben wird, um eine Aufladung des und/oder eine Ladungsübertragung zum Sensorelement (20) durchzuführen.

14. Verfahren nach einem der vorhergehenden Ansprüche,
**dadurch gekennzeichnet,**
**dass** das Ermitteln des wenigstens einen für die Erfassung spezifischen Parameters des Sensorelements (20) den nachfolgenden Schritt aufweist:
- Initiieren einer Ladungsübertragung zwischen dem Sensorelement (20) und einer Sensorkontrollanordnung (170), vorzugsweise durch ein elektrisches Signal gemäß der elektrischen Ansteuerung, um anhand der übertragenen Ladung den Parameter, vorzugsweise eine durch das Sensorelement (20) bereitgestellte veränderliche Kapazität (CS), zu ermitteln,
und/oder dass das Bereitstellen der elektrischen Ansteuerung über den Kontrollpfad (KP) für ein Schildelement (160) den nachfolgenden Schritt aufweist:
- Anlegen eines elektrischen Potentials am Schildelement (160) in Abhängigkeit von einem elektrischen Potential am Sensorelement (20) und/oder einem elektrischen Signal gemäß der elektrischen Ansteuerung, vorzugsweise eines elektrischen Signals mit einer vorgegebener Signalform, vorzugsweise einer oszillierenden und/oder zumindest annähernden Sinusform, welches durch eine Filteranordnung (140) und/oder eine Signalgeneratoranordnung (130) ausgegeben wird, um eine Aufladung des und/oder eine Ladungsübertragung zum Sensorelement (20) durchzuführen.

15. Verfahren nach einem der vorhergehenden Ansprüche,
**dadurch gekennzeichnet,**
**dass** eine Anordnung (10) nach einem der vorhergehenden Ansprüche betrieben wird.

## Claims

1. An arrangement (10) for a vehicle (1) for detecting an activation action for activating a function on the vehicle (1), in particular for detecting an activation action in a front, side, and/or rear area (1.7, 1.4, 1.2) of the vehicle (1) for activating the opening and/or unlocking of a flap (1.3, 1.6) on the vehicle (1), comprising:
- at least one sensor element (20) for detecting a change, in particular an approach by an activation means (3), in a vicinity of the sensor element (20),
- a control arrangement (100) which is electrically connected to the sensor element (20) via a control path (KP) for the electrical control of the sensor element (20) in order to provide the detection,
- an evaluation arrangement (200) for repeatedly determining at least one parameter of the sensor element (20) specific to the detection, in order to perform the detection of the activation action,
- at least one shield element (160) arranged adjacent to the sensor element (20) for shielding the sensor element (20),
- a shield control arrangement (150) which is electrically connected to the control path (KP) and the shield element (160) to provide the electrical control of the sensor element (20) for the shield element (160),
wherein the control arrangement (100) comprises a filter arrangement (140) for providing a filtered and/or shaped electrical signal for the electrical control of the sensor element (20) via the control path (KP), such that an emission of the sensor element (20) is adapted by the filter arrangement (140), wherein a sensor control arrangement (170) is connected to the sensor element (20) via a first connection (170.A), and is connected to the evaluation arrangement (200) via a second connection (170.B), and is connected via a third connection (170.C) to the filter arrangement (140), and a transmission arrangement (170.1, 170.2) comprises a voltage follower and/or voltage multiplier to generate an electrical potential at the third connection (170.C) in the same or amplified manner via the first connection (170.A) at the sensor element (20), and in the same or amplified manner via the second connection (170.B) at the evaluation arrangement (200) for the determination, wherein the filter arrangement (140) connects a signal generator arrangement (130) to the control path (KP) to provide an electrical signal generated by the signal generator arrangement (130) at the control path (KP) in a filtered and/or shaped form, and thereby to provide it as a filtered electrical signal.

2. An arrangement (10) according to claim 1,
**characterized in that**
the shield control arrangement (150) for electrically forcing the shield element (160) comprises an operational amplifier (150.1) which connects the control path (KP) to the shield element (160) to generate a shield voltage at the shield element (160) equal to a control voltage at the control path (KP), wherein preferably the control voltage is specific to and/or proportional to the electrical voltage at the sensor element (20), and/or that the shield control arrangement (150) forms a voltage follower and/or comprises direct negative feedback of a transfer element (150.1), such that an electrical potential at the shield element (160) follows the electrical potential at the control path (KP) and, in particular, at the sensor element (20),
and/or that the control arrangement (100) comprises a signal generator arrangement (130) which is electrically connected to the sensor element (20) for the electrical control of the sensor element (20) in order to repeatedly generate an electrical signal for charging the sensor element (20).

3. An arrangement (10) according to claim 1 or 2,
**characterized in that**
the sensor element (20) is configured as a sensor electrode (20) to provide the parameter specific to the detection as a variable capacitance (CS), wherein the change in capacitance (CS) is specific to the change in the environment, wherein the control arrangement (100) is configured to repeatedly initiate a charge transfer between the sensor element (20) and a sensor control arrangement (170) for repeated determination, in order to charge a storage arrangement (250), in particular an integrator (250), of the evaluation arrangement (200) so that the electrical charge stored by the storage arrangement (250) is specific to the change in capacitance (CS).

4. An arrangement (10) according to any one of the preceding claims,
**characterized in that**
a sensor control arrangement (170) is electrically connected to the sensor element (20) via a first connection (170.A) for charge transfer, and comprises an electronic amplifier arrangement (170.1, 170.2) for providing a sensor signal at a second connection (170.B) based on the charge transfer, such that the sensor signal is specific to a variable capacitance (CS) of the sensor element (20), wherein preferably a storage arrangement (250) of the evaluation arrangement (200) is connected to the sensor control arrangement (170) via the second connection (170.B) to perform charge accumulation at the storage arrangement (250) via the sensor signal, such that the electrical charge stored by the storage arrangement (250) is specific to the change in capacitance (CS).

5. An arrangement (10) according to any one of the preceding claims,
**characterized in that**
a control device (300) is connected to a storage arrangement (250) of the evaluation arrangement (200) to evaluate an electrical charge stored by the storage arrangement (250) for determining the parameter specific to the detection, preferably by analog-to-digital conversion of a voltage at the storage arrangement (250).

6. An arrangement (10) according to any one of the preceding claims,
**characterized in that**
the shield control arrangement (150) is electrically connected directly to the sensor element (20) and/or to an electrical potential at the sensor element (20) in order to directly match an electrical potential at the shield element (160) to the electrical potential at the sensor element (20),
and/or **in that** the shield control arrangement (150) is electrically connected to the sensor element (20) only indirectly, preferably via a sensor control arrangement (170) and/or via a switching element (180).

7. An arrangement (10) according to any one of the preceding claims,
**characterized in that**
the sensor control arrangement (170) is connected to the sensor element (20) via the first connection (170.A), and is connected to the evaluation arrangement (200) via the second connection (170.B), and is connected via a third connection (170.C) to the signal generator arrangement (130) and/or the filter arrangement (140), and comprises the transmission arrangement (170.1, 170.2) for generating the electrical potential at the third connection (170.C) in the same or amplified manner via the first connection (170.A) at the sensor element (20), and to generate it in the same or amplified manner via the second connection (170.B) at the evaluation arrangement (200) for the determination, such that the electrical potential at the sensor element (20) and/or the electrical potential at the second connection (170.B) follows the electrical potential at the third connection (170.C).

8. An arrangement (10) according to any one of the preceding claims,
**characterized in that**
the shield control arrangement (150) and a sensor control arrangement (170) are electrically connected to a common signal generator arrangement (130) and/or a common filter arrangement (140) in order to transmit an electrical signal generated by the signal generator arrangement (130) and/or filtered by the filter arrangement (140) to both the sensor element (20) and the shield element (160), preferably with a substantially identical waveform of the signal, preferably at least an approximately sinusoidal waveform, so that an electrical potential difference between the sensor element (20) and the shield element (160) is always minimized during operation of the arrangement (10) during the control and/or detection,
and/or that the shield element (160) is designed as an active shield element (160), such that, by means of the shield control arrangement (150), an electrical potential at the shield element (160) is actively tracked to the electrical potential at the sensor element (20),
and/or that the shield element (160) has a U-shape, with a central portion (160.1) for shielding in the central region and a side portion (160.2) for lateral shielding of the sensor element (20).

9. An arrangement (10) according to any one of the preceding claims,
**characterized in that**
the arrangement (10) is integrated, as a capacitive sensor arrangement, at least partially into a bumper (1.1) of the vehicle (1) to monitor the rear area (1.2) of the vehicle (1), and to perform, as the function on the vehicle (1), the opening of the tailgate (1.3) of the vehicle (1), in particular to initiate the output of an opening signal and/or an authentication check,
and/or that the arrangement (10) comprises a sensor control arrangement (170) for repeatedly transferring an electrical charge between the sensor control arrangement (170) and the sensor element (20) by the electrical control of the sensor element (20), and for charging a storage arrangement (250) in dependence on a charge quantity in the sensor element (20) for determining the at least one parameter of the sensor element (20) specific to the detection, wherein a control device (300), in particular at least one microcontroller, is electrically connected to the storage arrangement (250) in order to evaluate, after charging, the quantity of charge stored in the storage arrangement (250) and/or accumulated after multiple charging cycles, and to perform the detection based on the evaluation, preferably to output an activation signal for activating the function on the vehicle (1) when the stored and/or accumulated charge of the storage arrangement (250) exceeds a threshold value.

10. An arrangement (10) according to any one of the preceding claims,
**characterized in that**
the sensor element (20) is connected to the control arrangement (100) via a sensor lead (410), wherein the sensor lead (410) is twisted with a further shield element (420), each in the form of an electrical cable, wherein preferably the further shield element (420) is operated as a passive shield element, in particular is set to a fixed electrical potential independently of the potential of the sensor element (20),
and/or that the sensor element (20) is connected to the control arrangement (100) via a sensor lead (410), wherein the sensor lead (410) is configured as an inner conductor (450.1) of a coaxial cable (450), wherein an outer conductor (450.2) of the coaxial cable (450) is configured as the shield element (160), in particular an active shield element (160).

11. A system comprising:
- an arrangement (10) according to any one of the preceding claims,
- a control device (300) for outputting an activation signal upon detection of the activation action,
- a control unit (8) connected to the control device (300) to execute the function on the vehicle (1) upon receipt of the activation signal.

12. A method for a vehicle (1) for detecting an activation action for activating a function on the vehicle (1), in particular in a front, side, and/or rear area (1.7, 1.4, 1.2) of the vehicle (1) for activating the opening and/or unlocking of a flap (1.3, 1.6) on the vehicle (1), wherein
the following steps are performed:
- driving a sensor element (20) by an electrical control via a control path (KP) via a control arrangement (100) to provide a detection of a change, in particular an approach by an activation means (3), in a vicinity of the sensor element (20),
- determining at least one parameter of the sensor element (20) specific to the detection in order to perform the detection of the activation action,
- providing the electrical control via the control path (KP) for a shield element (160), which is arranged adjacent to the sensor element (20) for shielding the sensor element (20),
wherein the control arrangement (100) comprises a filter arrangement to provide a filtered and/or shaped electrical signal for the electrical control of the sensor element (20) via the control path, such that an emission of the sensor element is adapted by the filter arrangement,
wherein a sensor control arrangement (170) is connected to the sensor element (20) via a first connection (170.A), and is connected to the evaluation arrangement (200) via a second connection (170.B), and is connected via a third connection (170.C) to the filter arrangement (140), and a transmission arrangement (170.1, 170.2) comprises a voltage follower and/or voltage multiplier to generate an electrical potential at the third connection (170.C) in the same or amplified manner via the first connection (170.A) at the sensor element (20), and in the same or amplified manner via the second connection (170.B) at the evaluation arrangement (200) for the determination, wherein the filter arrangement (140) connects a signal generator arrangement (130) to the control path (KP) to provide an electrical signal generated by the signal generator arrangement at the control path (KP) in a filtered and/or shaped form, and thereby to provide a filtered electrical signal.

13. A method according to any one of the preceding claims,
**characterized in that**
the driving of the sensor element (20) comprises the following step:
- applying an electrical potential to the sensor element (20) in accordance with the electrical control, preferably by means of an electrical signal having a predetermined, in particular oscillating, signal shape, preferably at least approximately sinusoidal, which is output by a filter arrangement (140) and/or a signal generator arrangement (130) to effect charging of and/or charge transfer to the sensor element (20).

14. A method according to any one of the preceding claims,
**characterized in that**
the determination of the at least one parameter of the sensor element (20) specific to the detection comprises the following step:
- initiating a charge transfer between the sensor element (20) and a sensor control arrangement (170), preferably by means of an electrical signal in accordance with the electrical control, in order to determine, based on the transferred charge, the parameter, preferably a variable capacitance (CS) provided by the sensor element (20),
and/or that the providing of the electrical control via the control path (KP) for a shield element (160) comprises the following step:
- applying an electrical potential to the shield element (160) in dependence on an electrical potential at the sensor element (20) and/or an electrical signal in accordance with the electrical control, preferably an electrical signal with a predetermined signal shape, preferably an oscillating and/or at least approximately sinusoidal shape, which is output by a filter arrangement (140) and/or a signal generator arrangement (130) to effect charging of and/or charge transfer to the sensor element (20).

15. A method according to any one of the preceding claims,
**characterized in that**
an arrangement (10) according to any one of the preceding claims is operated.

## Revendications

1. Dispositif (10) pour un véhicule (1) destiné à détecter une action d'activation pour l'activation d'une fonction sur le véhicule (1), en particulier pour détecter une action d'activation dans une zone avant, latérale et/ou arrière (1.7, 1.4, 1.2) du véhicule (1) en vue de l'ouverture et/ou du déverrouillage d'un hayon (1.3, 1.6) sur le véhicule (1), comprenant :
- au moins un élément capteur (20) destiné à détecter un changement, en particulier un rapprochement d'un moyen d'activation (3), dans un environnement de l'élément capteur (20),
- un dispositif de commande (100) qui est relié électriquement à l'élément capteur (20) via un chemin de commande (KP) pour la commande électrique de l'élément capteur (20), afin d'assurer la détection,
- un dispositif d'évaluation (200) destiné à déterminer de manière répétée au moins un paramètre de l'élément capteur (20) spécifique à la détection, afin d'effectuer la détection de l'action d'activation,
- au moins un élément de blindage (160) qui est disposé à proximité de l'élément capteur (20) afin de blinder celui-ci,
- un dispositif de commande de blindage (150) qui est relié électriquement au chemin de commande (KP) et à l'élément de blindage (160) afin de fournir la commande électrique de l'élément capteur (20) à l'élément de blindage (160),
le dispositif de commande (100) comportant un dispositif de filtrage (140) destiné à fournir, via le chemin de commande (KP), un signal électrique filtré et/ou mis en forme pour la commande électrique de l'élément capteur (20), de sorte qu'une émission de l'élément capteur (20) est adaptée par le dispositif de filtrage (140), un dispositif de commande de capteur (170) étant connecté à l'élément capteur (20) via une première borne (170.A), et étant connecté au dispositif d'évaluation (200) via une deuxième borne (170.B), et étant connecté via une troisième borne (170.C) au dispositif de filtrage (140), et un dispositif de transmission (170.1, 170.2) comportant un suiveur de tension et/ou un multiplicateur de tension, afin de générer un potentiel électrique au niveau de la troisième borne (170.C) de manière identique ou amplifiée via la première borne (170.A) sur l'élément capteur (20), et de manière identique ou amplifiée via la deuxième borne (170.B) sur le dispositif d'évaluation (200) à des fins de détermination, le dispositif de filtrage (140) reliant un dispositif générateur de signaux (130) au chemin de commande (KP) afin de fournir un signal électrique généré par le dispositif générateur de signaux (130) sur le chemin de commande (KP) sous une forme filtrée et/ou mise en forme, et de le fournir ainsi sous la forme d'un signal électrique filtré.

2. Dispositif (10) selon la revendication 1,
**caractérisé en ce que**
le dispositif de commande de blindage (150) destiné à la commande électrique forcée de l'élément de blindage (160) comporte un amplificateur opérationnel (150.1) qui relie le chemin de commande (KP) à l'élément de blindage (160) afin de générer une tension de blindage au niveau de l'élément de blindage (160) égale à une tension de commande au niveau du chemin de commande (KP), la tension de commande étant de préférence spécifique à la tension électrique au niveau de l'élément capteur (20) et/ou proportionnelle à celle-ci,
et/ou **en ce que** le dispositif de commande de blindage (150) forme un suiveur de tension et/ou comporte une contre-réaction directe d'un élément de transmission (150.1), de sorte qu'un potentiel électrique au niveau de l'élément de blindage (160) suit le potentiel électrique au niveau du chemin de commande (KP) et en particulier au niveau de l'élément capteur (20),
et/ou **en ce que** le dispositif de commande (100) comporte un dispositif générateur de signaux (130) qui, pour la commande électrique de l'élément capteur (20), est connecté électriquement à l'élément capteur (20) afin de générer de manière répétée un signal électrique pour charger l'élément capteur (20).

3. Dispositif (10) selon la revendication 1 ou 2,
**caractérisé en ce que**
l'élément capteur (20) est conçu comme une électrode de capteur (20) afin de fournir le paramètre spécifique à la détection sous la forme d'une capacité variable (CS), la variation de la capacité (CS) étant spécifique à la variation de l'environnement, le dispositif de commande (100) étant conçu pour initier de manière répétée, en vue d'une détermination répétée, un transfert de charge entre l'élément capteur (20) et un dispositif de commande de capteur (170), afin de charger un dispositif de stockage (250), en particulier un intégrateur (250), du dispositif d'évaluation (200), en fonction du transfert de charge, de sorte que la charge électrique stockée par le dispositif de stockage (250) soit spécifique à la variation de capacité (CS).

4. Dispositif (10) selon l'une des revendications précédentes,
**caractérisé en ce qu'**
un dispositif de commande de capteur (170) est connecté électriquement à l'élément capteur (20) via une première borne (170.A) pour le transfert de charge, et comporte un dispositif amplificateur électronique (170.1, 170.2) pour fournir, au niveau d'une deuxième borne (170.B), un signal de capteur sur la base du transfert de charge, de sorte que le signal de capteur est spécifique à une capacité variable (CS) de l'élément capteur (20), un dispositif de stockage (250) du dispositif d'évaluation (200) étant de préférence connecté au dispositif de commande de capteur (170) via la deuxième borne (170.B) afin d'effectuer, par le signal de capteur, une accumulation de charge au niveau du dispositif de stockage (250), de sorte que la charge électrique stockée par le dispositif de stockage (250) est spécifique à la variation de la capacité (CS).

5. Dispositif (10) selon l'une des revendications précédentes,
**caractérisé en ce qu'**
un dispositif de contrôle (300) est connecté à un dispositif de stockage (250) du dispositif d'évaluation (200) afin d'évaluer une charge électrique stockée par le dispositif de stockage (250) pour déterminer le paramètre spécifique à la détection, de préférence par une conversion analogique-numérique d'une tension au niveau du dispositif de stockage (250).

6. Dispositif (10) selon l'une des revendications précédentes,
**caractérisé en ce que**
le dispositif de commande de blindage (150) est relié électriquement directement à l'élément capteur (20) et/ou à un potentiel électrique au niveau de l'élément capteur (20), afin d'aligner directement un potentiel électrique au niveau de l'élément de blindage (160) sur le potentiel électrique au niveau de l'élément capteur (20), et/ou **en ce que** le dispositif de commande de blindage (150) n'est relié électriquement qu'indirectement à l'élément capteur (20), de préférence via un dispositif de commande de capteur (170) et/ou via un élément de commutation (180).

7. Dispositif (10) selon l'une des revendications précédentes,
**caractérisé en ce que**
le dispositif de commande de capteur (170) est connecté à l'élément capteur (20) via la première borne (170.A), est connecté au dispositif d'évaluation (200) via la deuxième borne (170.B), et est connecté via la troisième borne (170.C) au dispositif générateur de signaux (130) et/ou au dispositif de filtrage (140), et comprend le dispositif de transmission (170.1, 170.2) pour générer le potentiel électrique au niveau de la troisième borne (170.C) de manière identique ou amplifiée via la première borne (170.A) sur l'élément capteur (20), et pour le générer de manière identique ou amplifiée via la deuxième borne (170.B) au niveau du dispositif d'évaluation (200) à des fins de détermination, de sorte que le potentiel électrique au niveau de l'élément capteur (20) et/ou le potentiel électrique au niveau de la deuxième borne (170.B) suive le potentiel électrique au niveau de la troisième borne (170.C).

8. Dispositif (10) selon l'une des revendications précédentes,
**caractérisé en ce que**
le dispositif de commande de blindage (150) et un dispositif de commande de capteur (170) sont connectés électriquement à un même dispositif générateur de signaux (130) et/ou à un même dispositif de filtrage (140), afin qu'un signal électrique généré par le dispositif générateur de signaux (130) et/ou filtré par le dispositif de filtrage (140) soit transmis à la fois à l'élément capteur (20) et à l'élément de blindage (160), de préférence avec une forme d'onde du signal sensiblement identique, de préférence une forme sinusoïdale au moins approximative, de sorte qu'une différence de potentiel électrique entre l'élément capteur (20) et l'élément de blindage (160) soit toujours minimisée pendant le fonctionnement du dispositif (10) lors de la commande et/ou de la détection,
et/ou **en ce que** l'élément de blindage (160) est réalisé sous la forme d'un élément de blindage actif (160), de sorte que, au moyen du dispositif de commande de blindage (150), un potentiel électrique au niveau de l'élément de blindage (160) est activement suivi du potentiel électrique au niveau de l'élément capteur (20),
et/ou **en ce que** l'élément de blindage (160) présente une forme en U, avec une partie centrale (160.1) pour le blindage dans la zone centrale et une partie latérale (160.2) pour le blindage latéral de l'élément capteur (20).

9. Dispositif (10) selon l'une des revendications précédentes,
**caractérisé en ce que**
le dispositif (10) est intégré, en tant que dispositif de capteur capacitif, au moins partiellement dans un pare-chocs (1.1) du véhicule (1) afin de surveiller la zone arrière (1.2) du véhicule (1), et afin d'assurer, en tant que fonction sur le véhicule (1), l'ouverture du hayon (1.3) du véhicule (1), en particulier pour déclencher l'émission d'un signal d'ouverture et/ou un contrôle d'authentification,
et/ou **en ce que** le dispositif (10) comporte un dispositif de commande de capteur (170) destiné à transférer de manière répétée, par la commande électrique de l'élément capteur (20), une charge électrique entre le dispositif de commande de capteur (170) et l'élément capteur (20), et à charger, pour la détermination du au moins un paramètre spécifique à la détection de l'élément capteur (20), un dispositif de stockage (250) en fonction d'une quantité de charge dans l'élément capteur (20), un dispositif de contrôle (300), en particulier au moins un microcontrôleur, étant relié électriquement au dispositif de stockage (250) afin d'évaluer, après la charge, la quantité de charge stockée dans le dispositif de stockage (250) et/ou accumulée après plusieurs charges, et d'effectuer la détection sur la base de cette évaluation, de préférence pour émettre un signal d'activation destiné à activer la fonction sur le véhicule (1) lorsque la charge stockée et/ou accumulée du dispositif de stockage (250) dépasse une valeur limite.

10. Dispositif (10) selon l'une des revendications précédentes,
**caractérisé en ce que**
l'élément capteur (20) est relié au dispositif de commande (100) par l'intermédiaire d'un câble de capteur (410), le câble de capteur (410) étant torsadé avec un autre élément de blindage (420), chacun se présentant sous la forme d'un câble électrique, l'autre élément de blindage (420) étant de préférence exploité comme un élément de blindage passif, en particulier mis à un potentiel électrique fixe indépendamment du potentiel de l'élément capteur (20),
et/ou **en ce que** l'élément capteur (20) est relié au dispositif de commande (100) par l'intermédiaire d'un câble de capteur (410), le câble de capteur (410) étant conçu comme conducteur interne (450.1) d'un câble coaxial (450), un conducteur externe (450.2) du câble coaxial (450) étant conçu comme l'élément de blindage (160), en particulier l'élément de blindage actif (160).

11. Système comprenant :
- un dispositif (10) selon l'une des revendications précédentes,
- un dispositif de contrôle (300) destiné à émettre un signal d'activation en cas de détection de l'action d'activation,
- un appareil de commande (8) relié au dispositif de contrôle (300) pour exécuter la fonction sur le véhicule (1) à la réception du signal d'activation.

12. Procédé pour un véhicule (1) destiné à détecter une action d'activation pour l'activation d'une fonction sur le véhicule (1), en particulier dans une zone avant, latérale et/ou arrière (1.7, 1.4, 1.2) du véhicule (1) pour l'activation d'une ouverture et/ou d'un déverrouillage d'un hayon (1.3, 1.6) sur le véhicule (1), dans lequel les étapes suivantes sont exécutées :
- commande d'un élément capteur (20) par une commande électrique via un chemin de commande (KP) via un dispositif de commande (100), afin de permettre la détection d'un changement, en particulier d'un rapprochement par un moyen d'activation (3), dans l'environnement de l'élément capteur (20),
- détermination d'au moins un paramètre spécifique à la détection de l'élément capteur (20) afin d'effectuer la détection de l'action d'activation,
- fourniture de la commande électrique via le chemin de commande (KP) à un élément de blindage (160), qui est disposé à proximité de l'élément capteur (20) pour le blinder, un dispositif de commande (100) comprend un dispositif de filtrage afin de fournir, via le chemin de commande, un signal électrique filtré et/ou mis en forme pour la commande électrique de l'élément capteur (20), de sorte qu'une émission de l'élément capteur soit adaptée par le dispositif de filtrage,
un dispositif de commande de capteur (170) étant connecté à l'élément capteur (20) via une première borne (170.A), et étant connecté au dispositif d'évaluation (200) via une deuxième borne (170.B), et étant connecté via une troisième borne (170.C) au dispositif de filtrage (140), et un dispositif de transmission (170.1, 170.2) comportant un suiveur de tension et/ou un multiplicateur de tension, afin de générer un potentiel électrique au niveau de la troisième borne (170.C) de manière identique ou amplifiée via la première borne (170.A) au niveau de l'élément capteur (20), et de manière identique ou amplifiée via la deuxième borne (170.B) au niveau du dispositif d'évaluation (200) en vue de la détermination,
le dispositif de filtrage (140) reliant un dispositif générateur de signaux (130) au chemin de commande (KP) afin de fournir, sur le chemin de commande (KP), un signal électrique généré par le dispositif générateur de signaux, filtré et/ou mis en forme, et de fournir ainsi un signal électrique filtré.

13. Procédé selon l'une des revendications précédentes,
**caractérisé en ce que**
la commande de l'élément capteur (20) comprend l'étape suivante :
- application d'un potentiel électrique à l'élément capteur (20) conformément à la commande électrique, de préférence par un signal électrique ayant une forme d'onde prédéfinie, en particulier oscillante, de préférence une forme sinusoïdale au moins approximative, qui est émis par un dispositif de filtrage (140) et/ou un dispositif générateur de signaux (130) afin d'effectuer une charge de l'élément capteur (20) et/ou un transfert de charge vers celui-ci.

14. Procédé selon l'une des revendications précédentes,
**caractérisé en ce que**
la détermination d'au moins un paramètre spécifique à la détection de l'élément capteur (20) comprend l'étape suivante :
- le déclenchement d'un transfert de charge entre l'élément capteur (20) et un dispositif de commande de capteur (170), de préférence par un signal électrique conforme à la commande électrique, afin de déterminer, à l'aide de la charge transférée, le paramètre, de préférence une capacité variable (CS) fournie par l'élément capteur (20),
et/ou **en ce que** la fourniture de la commande électrique via le chemin de commande (KP) pour un élément de blindage (160) comprend l'étape suivante :
- application d'un potentiel électrique à l'élément de blindage (160) en fonction d'un potentiel électrique au niveau de l'élément capteur (20) et/ou d'un signal électrique conformément à la commande électrique, de préférence d'un signal électrique ayant une forme d'onde prédéfinie, de préférence une forme d'onde oscillante et/ou au moins approximativement sinusoïdale, qui est émis par un dispositif de filtrage (140) et/ou un dispositif générateur de signaux (130), afin d'effectuer une charge de l'élément capteur (20) et/ou un transfert de charge vers celui-ci.

15. Procédé selon l'une des revendications précédentes,
**caractérisé en ce qu'**
un dispositif (10) selon l'une des revendications précédentes est mis en œuvre.
